# EUROPEAN PATENT SPECIFICATION

(11) **EP 3 307 745 B1**
(45) Date of publication and mention of the grant of the patent: **01.04.2020**
(21) Application number: 16808437.4
(22) Date of filing: 10.06.2016
(51) Int. Cl.: C07F 7/02, C23C 16/455, C01B 21/087, C01B 21/088, C23C 16/30, C23C 16/34, C23C 16/40, C23C 16/515

(54) **VAPOR DEPOSITION PROCESSES FOR FORMING SILICON- AND NITROGEN-CONTAINING THIN FILMS**
DAMPFABSCHEIDEVERFAHREN ZUR BILDUNG VON SILICIUM- UND STICKSTOFFHALTIGEN DÜNNSCHICHTEN
PROCÉDÉS DE DÉPÔT EN PHASE VAPEUR POUR FORMER DES FILMS MINCES CONTENANT DU SILICIUM ET DE L'AZOTE

(30) Priority: 12.06.2015 US 201514738039; 30.03.2016 WO PCT/US2016/025010
(43) Date of publication of application: 18.04.2018
(73) Proprietor: L'Air Liquide Société Anonyme pour l'Etude et l'Exploitation des Procédés Georges Claude, 75007 Paris (FR)
(72) Inventor: GIRARD, Jean-Marc, F-78000 Versailles (FR); ZHANG, Peng, Montvale, New Jersey 07645 (US); SANCHEZ, Antonio, Jersey City, New Jersey 07302 (US); KHANDELWAL, Manish, Somerset, New Jersey 08873 (US); ITOV, Gennadiy, Flemington, New Jersey 08822 (US); PESARESI, Reno, Easton, Pennsylvania 18042 (US)
(74) Representative: Grout de Beaufort, François-Xavier
(86) International application number: PCT/US2016/037013
(87) International publication number: WO 2016/201320

(56) References cited:
- EP-A1- 3 431 629
- EP-A2- 1 149 934
- KR-A- 20120 099 270
- US-A- 5 413 813
- US-A1- 2012 213 940
- US-A1- 2012 213 940
- US-A1- 2012 220 139
- US-A1- 2014 051 264
- US-A1- 2014 051 264
- WILLIAM M. SCANTLIN ET AL: "Pentaborane(9)-catalysed condensation of silylamines", JOURNAL OF THE CHEMICAL SOCIETY, CHEMICAL COMMUNICATIONS., no. 20, 1 January 1971 (1971-01-01), pages 1246-1246, XP055275715, GB ISSN: 0022-4936, DOI: 10.1039/c29710001246
- WILLIAM M. SCANTLIN ET AL: "Borane-catalyzed condensation of trisilazane and N-methyldisilazane", INORGANIC CHEMISTRY, vol. 11, no. 12, 1 December 1972 (1972-12-01), pages 3082-3084, XP055245955, EASTON, US ISSN: 0020-1669, DOI: 10.1021/ic50118a041

## Description

### Cross Reference to Related Applications

The present application claims the benefit of PCT App. No. PCT/US2016/025010 filed March 30, 2016 and U.S. App. No. 14/738,039 filed June 12, 2015.

### Technical Field

ALD processes for forming the silicon and nitrogen containing films using mono-substituted TSA precursors are disclosed. The mono-substituted TSA precursors have the formula: (SiH₃)₂N-SiH₂-X, wherein X is an amino group.

### Background

A variety of silicon containing precursor have been used to deposit Si-containing thin films on various substrates by vapor deposition processes. The choice of the suitable silicon precursor and, when applicable, of the co-reactant are generally driven by the target film composition and properties, as well as by the constraints brought by the substrate on which the film is to be deposited. Some substrates may require low temperature deposition processes. For instance, deposition on plastic substrates or Si substrates coated with organic films may require deposition temperatures below 100°C (i.e., 20°C-100°C), while maintaining a reasonable deposition rate to be of industrial interest. Such films may be used as spacer-defined lithography application in semiconductor fabrication, but also for sealing organic light-emitting diode (OLED) devices or creating moisture diffusion barriers on films. Similar constraints at different temperature ranges appear in the different steps of semiconductor manufacturing, such as, capping layers over metals, gate spacers, *etc.*

WO2015/190749 to DNF Co., Ltd., discloses Amino-silyl Amine Compounds and the Manufacturing Method of Dielectric Film Containing Si-N Bond by Using Atomic Layer Deposition. WO2015/047914 to Sanchez and Girard disclose Amine Substituted Trisilylamine and Tridisilylamine Compounds. US2014/0363985 to DNF Co., Ltd., discloses Amino-silyl Amine Compounds, Methods for Preparing the Same and Silicon-containing Thin-Film Using the Same. US5413813 to Cruse et al. disclose CVD of silicon-based ceramic materials on internal surfaces of a reactor using, among others, R₃Si-N(X)-SiR₃, wherein each R is H, C₁₋₂₀ alkyl, halogen (preferably CI) or NR₂ and X is H, Li, or SiR₃. US2014/0158580A to Air Products and Chemicals, Inc., describes Alkoxysilylamine Compounds and Applications Thereof. US 7,122,222, also to Air Products and Chemicals, Inc., discloses Precursors for Depositing Silicon Containing Films and Processes Thereof. Silazane compounds N-(SiR¹R²R³)ₘR⁴₃₋ₘ disclosed in WO2013/058061 are used as a coating gas. (RR¹R²M^{a})_{y}A(R³)ₓ disclosed in US 5,332,853 is used as a catalytic compound to produce a functionalized alkylalkali metal compound. Similar patents include US 5663398A, US 5332853A, US 5340507A, and EP 525881 A1. Further relevant prior art is disclosed in the the document US 2014/051264 A1.

Industries using vapor-based deposition processes such as CVD or ALD (in all possible meanings, such as LPCVD, SACVD, PECVD, PEALD, *etc*.) are still looking for precursors that are ideal for their applications, i.e. having the highest possible deposition rates within the constraints of their processes, substrates and film targets.

### Summary

The present invention is defined by the subject-matter of the appended claims. Disclosed are Si-containing film forming compositions comprising a mono-substituted TSA precursor having the formula (SiH₃)₂NSiH₂-X, wherein X is a halogen atom selected from CI, Br or I; an isocyanato group [-NCO]; an amino group [-NR¹R²]; a N-containing C₄-C₁₀ saturated or unsaturated heterocycle; or an alkoxy group [-O-R]; R¹, R² and R is independently selected from H; a silyl group [-SiR'₃]; or a C₁-C₆ linear or branched, saturated or unsaturated hydrocarbyl group; with each R' being independently selected from H; a halogen atom selected from CI, Br, or I; a C₁-C₄ saturated or unsaturated hydrocarbyl group; a C₁-C₄ saturated or unsaturated alkoxy group; or an amino group [-NR³R⁴] with each R³ and R⁴ being independently selected from H and a C₁-C₆ linear or branched, saturated or unsaturated hydrocarbyl group, provided that if R¹ = H, then R² ≠ H, Me or Et. The disclosed Si-containing film forming compositions may include one or more of the following aspects:
- the mono-substituted TSA precursor wherein X is a halogen atom;
- the mono-substituted TSA precursor being (SiH₃)₂N-SiH₂-Cl;
- the mono-substituted TSA precursor being (SiH₃)₂N-SiH₂-Br;
- the mono-substituted TSA precursor being (SiH₃)₂N-SiH₂-I;
- the mono-substituted TSA precursor wherein X is a isocyanate -NCO (i.e., being (SiH₃)₂N-SiH₂-NCO);
- the mono-substituted TSA precursor wherein X is an amino group [-NR¹R²];
- the mono-substituted TSA precursor being (SiH₃)₂N-SiH₂-NMe₂;
- the mono-substituted TSA precursor being (SiH₃)₂N-SiH₂-NMeEt;
- the mono-substituted TSA precursor being (SiH₃)₂N-SiH₂-NEt₂;
- the mono-substituted TSA precursor being (SiH₃)₂N-SiH₂-NiPr₂;
- the mono-substituted TSA precursor being (SiH₃)₂N-SiH₂-NHiPr;
- the mono-substituted TSA precursor being (SiH₃)₂N-SiH₂-NMeiPr;
- the mono-substituted TSA precursor being (SiH₃)₂N-SiH₂-NEtiPr;
- the mono-substituted TSA precursor being (SiH₃)₂N-SiH₂-NHtBu;
- the mono-substituted TSA precursor not being (SiH₃)₂-N-SiH₂-N(SiH₃)(SiH₂(NHEt)) (i.e., when X=NR¹R² and R¹ is SiH₃ and R² is NHEt);
- the mono-substituted TSA precursor wherein X is -N(SiR₃)₂, wherein each R is independently selected from a halogen, H, or a C₁-C₄ alkyl group;
- the mono-substituted TSA precursor being (SiH₃)₂N-SiH₂-N(SiCl₃)₂;
- the mono-substituted TSA precursor being (SiH₃)₂N-SiH₂-N(SiBr₃)₂;
- the mono-substituted TSA precursor being (SiH₃)₂N-SiH₂-N(SiI₃)₂;
- the mono-substituted TSA precursor being (SiH₃)₂N-SiH₂-N(SiH₃)₂;
- the mono-substituted TSA precursor being (SiH₃)₂-N-SiH₂-N(SiH₃)(SiH₂Cl);
- the mono-substituted TSA precursor being (SiH₃)₂-N-SiH₂-N(SiH₃)(SiH₂(NEt₂);
- the mono-substituted TSA precursor being (SiH₃)₂-N-SiH₂-N(Si0048₃)(SiH₂(NiPr₂);
- the mono-substituted TSA precursor being (SiH₃)₂-N-SiH₂-N(SiH₃)(SiH₂(NHtBu);
- the mono-substituted TSA precursor being (SiH₃)₂-N-SiH₂-N(SiH₃)(SiH₂OEt);
- the mono-substituted TSA precursor being (SiH₃)₂-N-SiH₂-N(SiH₃)(SiH₂OiPr);
- the mono-substituted TSA precursor being (SiH₃)₂N-SiH₂-N(SiMe₃)₂;
- the mono-substituted TSA precursor being (SiH₃)₂N-SiH₂-NH(SiMe₃);
- the mono-substituted TSA precursor being (SiH₃)₂N-SiH₂-N(SiEt₃)_{2;}
- the mono-substituted TSA precursor being (SiH₃)₂-N-SiH₂-N(SiMe₂Et)₂;
- the mono-substituted TSA precursor being (SiH₃)₂-N-SiH₂-N(SiMe₂iPr)₂;
- the mono-substituted TSA precursor being (SiH₃)₂-N-SiH₂-N(SiMe₂nPr)₂;.
- the mono-substituted TSA precursor wherein X is a N-containing C₄-C₁₀ heterocycle;
- the mono-substituted TSA precursor wherein the N-containing C₄-C₁₀ heterocycle is selected from pyrrolidine, pyrrole, and piperidine;
- the mono-substituted TSA precursor being (SiH₃)₂N-SiH₂-(pyrrolidine);
- the mono-substituted TSA precursor being (SiH₃)₂N-SiH₂-(pyrrole);
- the mono-substituted TSA precursor being (SiH₃)₂N-SiH₂-(piperidine);
- the mono-substituted TSA precursor wherein X is an alkoxy group [-O-R];
- the mono-substituted TSA precursor being (SiH₃)₂N-SiH₂-(OH);
- the mono-substituted TSA precursor being (SiH₃)₂N-SiH₂-(OMe);
- the mono-substituted TSA precursor being (SiH₃)₂N-SiH₂-(OEt);
- the mono-substituted TSA precursor being (SiH₃)₂N-SiH₂-(OiPr);
- the mono-substituted TSA precursor being (SiH₃)₂N-SiH₂-(OnPr);
- the mono-substituted TSA precursor being (SiH₃)₂N-SiH₂-(OtBu);
- the mono-substituted TSA precursor wherein X is -O-SiR₃ and each R is independently selected from H, a halogen, or a C₁-C₄ hydrocarbyl group;
- the mono-substituted TSA precursor being (SiH₃)₂N-SiH₂-(OSiH₃);
- the mono-substituted TSA precursor being (SiH₃)₂N-SiH₂-(OSiCl₃);
- the mono-substituted TSA precursor being (SiH₃)₂N-SiH₂-(OSiBr₃);
- the mono-substituted TSA precursor being (SiH₃)₂N-SiH₂-(OSiI₃);
- the mono-substituted TSA precursor being (SiH₃)₂N-SiH₂-(OSiMe₃);
- the Si-containing film forming composition comprising between approximately 95% w/w and approximately 100% w/w of the precursor;
- the Si-containing film forming composition comprising between approximately 5 % w/w and approximately 50% w/w of the precursor;
- the Si-containing film forming composition comprising between approximately 0 ppbw and approximately 500 ppbw Al;
- the Si-containing film forming composition comprising between approximately 0 ppbw and approximately 500 ppbw As;
- the Si-containing film forming composition comprising between approximately 0 ppbw and approximately 500 ppbw Ba;
- the Si-containing film forming composition comprising between approximately 0 ppbw and approximately 500 ppbw Be;
- the Si-containing film forming composition comprising between approximately 0 ppbw and approximately 500 ppbw Bi;
- the Si-containing film forming composition comprising between approximately 0 ppbw and approximately 500 ppbw Cd;
- the Si-containing film forming composition comprising between approximately 0 ppbw and approximately 500 ppbw Ca;
- the Si-containing film forming composition comprising between approximately 0 ppbw and approximately 500 ppbw Cr;
- the Si-containing film forming composition comprising between approximately 0 ppbw and approximately 500 ppbw Co;
- the Si-containing film forming composition comprising between approximately 0 ppbw and approximately 500 ppbw Cu;
- the Si-containing film forming composition comprising between approximately 0 ppbw and approximately 500 ppbw Ga;
- the Si-containing film forming composition comprising between approximately 0 ppbw and approximately 500 ppbw Ge;
- the Si-containing film forming composition comprising between approximately 0 ppbw and approximately 500 ppbw Hf;
- the Si-containing film forming composition comprising between approximately 0 ppbw and approximately 500 ppbw Zr;
- the Si-containing film forming composition comprising between approximately 0 ppbw and approximately 500 ppbw In;
- the Si-containing film forming composition comprising between approximately 0 ppbw and approximately 500 ppbw Fe;
- the Si-containing film forming composition comprising between approximately 0 ppbw and approximately 500 ppbw Pb;
- the Si-containing film forming composition comprising between approximately 0 ppbw and approximately 500 ppbw Li;
- the Si-containing film forming composition comprising between approximately 0 ppbw and approximately 500 ppbw Mg;
- the Si-containing film forming composition comprising between approximately 0 ppbw and approximately 500 ppbw Mn;
- the Si-containing film forming composition comprising between approximately 0 ppbw and approximately 500 ppbw W;
- the Si-containing film forming composition comprising between approximately 0 ppbw and approximately 500 ppbw Ni;
- the Si-containing film forming composition comprising between approximately 0 ppbw and approximately 500 ppbw K;
- the Si-containing film forming composition comprising between approximately 0 ppbw and approximately 500 ppbw Na;
- the Si-containing film forming composition comprising between approximately 0 ppbw and approximately 500 ppbw Sr;
- the Si-containing film forming composition comprising between approximately 0 ppbw and approximately 500 ppbw Th;
- the Si-containing film forming composition comprising between approximately 0 ppbw and approximately 500 ppbw Sn;
- the Si-containing film forming composition comprising between approximately 0 ppbw and approximately 500 ppbw Ti;
- the Si-containing film forming composition comprising between approximately 0 ppbw and approximately 500 ppbw U;
- the Si-containing film forming composition comprising between approximately 0 ppbw and approximately 500 ppbw V;
- the Si-containing film forming composition comprising between approximately 0 ppbw and approximately 500 ppbw Zn;
- the Si-containing film forming organosilane composition comprising between approximately 0 ppmw and approximately 500 ppmw CI;
- the Si-containing film forming composition comprising between approximately 0 ppmw and approximately 500 ppmw Br;
- the Si-containing film forming composition comprising between approximately 0 ppmw and approximately 500 ppmw I;
- the Si-containing film forming composition comprising between approximately 0.0% w/w and 0.1 % w/w TSA;
- the Si-containing film forming composition comprising between approximately 0.0% w/w and 0.1% w/w (SiH₃)₂-N-SiH₂X, wherein X is Cl, Br, or I;
- the Si-containing film forming composition comprising between approximately 0.0% w/w and 0.1% w/w (SiH₃)₂-N-SiHX₂, wherein X is Cl, Br, or I;
- the Si-containing film forming composition comprising between approximately 0.0% w/w and 0.1% w/w SiH₄;
- the Si-containing film forming composition comprising between approximately 0.0% w/w and 0.1% w/w SiH₃X, wherein X is CI, Br, or I;
- the Si-containing film forming composition comprising between approximately 0.0% w/w and 0.1% w/w SiH₂X₂, wherein X is CI, Br, or I;
- the Si-containing film forming composition comprising between approximately 0.0% w/w and 0.1% w/w SnX₂, wherein X is CI, Br, or I;
- the Si-containing film forming composition comprising between approximately 0.0% w/w and 0.1% w/w SnX₄, wherein X is CI, Br, or I;
- the Si-containing film forming composition comprising between approximately 0.0% w/w and 0.1% w/w HX, wherein X is CI, Br, or I;
- the Si-containing film forming composition comprising between approximately 0.0% w/w and 0.1% w/w NH₃;
- the Si-containing film forming composition comprising between approximately 0.0% w/w and 0.1% w/w NH₄X, wherein X is CI, Br, or I;
- the Si-containing film forming composition comprising between approximately 0.0% w/w and 0.1% w/w ROH, wherein R is C1-C4 alkyl group;
- the Si-containing film forming composition comprising between approximately 0.0% w/w and 0.1% w/w NH₂R, wherein R is a C1-C4 alkyl group;
- the Si-containing film forming composition comprising between approximately 0.0% w/w and 0.1% w/w NR₂H, wherein R is a C1-C4 alkyl group;
- the Si-containing film forming composition comprising between approximately 0.0% w/w and 0.1% w/w HN=R, wherein R is a C1-C4 alkyl group;
- the Si-containing film forming composition comprising between approximately 0.0% w/w and 0.1% w/w tetrahydrofuran (THF);
- the Si-containing film forming composition comprising between approximately 0.0% w/w and 0.1 % w/w ether;
- the Si-containing film forming composition comprising between approximately 0.0% w/w and 0.1 % w/w pentane;
- the Si-containing film forming composition comprising between approximately 0.0% w/w and 0.1 % w/w cyclohexane;
- the Si-containing film forming composition comprising between approximately 0.0% w/w and 0.1% w/w heptane; or
- the Si-containing film forming composition comprising between approximately 0.0% w/w and 0.1% w/w toluene.

Also disclosed are Si-containing film forming composition delivery devices comprising a canister having an inlet conduit and an outlet conduit and containing any of the Si-containing film forming compositions disclosed above. The disclosed device may include one or more of the following aspects:
- the Si-containing film forming composition having a total concentration of metal contaminants of less than 10 ppmw;
- an end of the inlet conduit end located above a surface of the Si-containing film forming composition and an end of the outlet conduit located below the surface of the Si-containing film forming composition;
- an end of the inlet conduit end located below a surface of the Si-containing film forming composition and an end of the outlet conduit located above the surface of the Si-containing film forming composition;
- further comprising a diaphragm valve on the inlet and the outlet;
- the Si-containing film forming composition being (H₃Si)₂N-SiH₂(NEt₂),;
- the Si-containing film forming composition being (H₃Si)₂N-SiH₂(NiPr₂);
- the Si-containing film forming composition being (H₃Si)₂N-SiH₂Cl; and
- the Si-containing film forming composition being (H₃Si)₂N-SiH2(N(SiMe₃)₂.

Also disclosed are methods of depositing a Si-containing layer on a substrate. The composition disclosed above is introduced into a reactor having a substrate disposed therein. At least part of the mono-substituted TSA precursor is deposited onto the substrate to form the Si-containing layer using a vapor deposition method. The disclosed methods may have one or more of the following aspects:
- introducing into the reactor a vapor comprising a second precursor;
- an element of the second precursor being selected from the group consisting of group 2, group 13, group 14, transition metal, lanthanides, and combinations thereof;
- the element of the second precursor being selected from As, B, P, Si, Ge, Al, Zr, Hf, Ti, Nb, Ta, or lanthanides;
- introducing a reactant into the reactor;
- the reactant being selected from the group consisting of O₂, O₃, H₂O, H₂O₂, NO, NO₂, a carboxylic acid, an alcohol, a diol, radicals thereof, and combinations thereof;
- the reactant being plasma treated oxygen;
- the Si-containing layer being a silicon oxide containing layer;
- the reactant being selected from the group consisting of N₂, H₂, NH₃, hydrazines (such as N₂H₄, MeHNNH₂, MeHNNHMe), organic amines (such as NMeH₂, NEtH₂, NMe₂H, NEt₂H, NMe₃, NEt₃, (SiMe₃)₂NH), pyrazoline, pyridine, diamines (such as ethylene diamine), radical species thereof, and mixtures thereof;
- the vapor deposition method being a chemical vapor deposition process;
- the vapor deposition method being an ALD process;
- the vapor deposition method being a spatial ALD process;
- the vapor deposition process being a flowable CVD process;
- the silicon-containing layer being Si;
- the silicon-containing layer being SiO₂;
- the silicon-containing layer being SiN;
- the silicon-containing layer being SiON;
- the silicon-containing layer being SiOC;
- the silicon-containing layer being SiOCN;
- the silicon-containing layer being SiCN;
- thermal annealing the Si-containing layer;
- thermal annealing the Si-containing layer under a reactive atmosphere;
- UV curing the Si-containing layer; and
- Electron beam curing the Si-containing layer.

Also disclosed are nitrogen-doped silicon oxide films formed by the process of introducing into a reactor containing a substrate a vapor including a mono-substituted TSA precursor to form a silicon-containing layer on the substrate; reacting an oxidizing agent with the silicon-containing layer to form an oxidized silicon-containing layer by introducing the oxidizing agent into the reactor; reacting the mono-substituted TSA precursor with the oxidized silicon-containing layer to form a silicon-rich oxidized silicon-containing layer by introducing the mono-substituted TSA precursor into the reactor; and reacting a nitrogen-containing reactant with the silicon-containing layer to form the nitrogen-doped silicon oxide film by introducing the nitrogen-containing reactant into the reactor. The mono-substituted TSA precursors have a formula (SiH₃)₂N-SiH₂-X, wherein X is selected from a halogen atom selected from CI, Br or I; an isocyanato group [-NCO]; an amino group [-NR¹R²]; a N-containing C₄-C₁₀ saturated or unsaturated heterocycle; or an alkoxy group [-O-R]; R¹, R² and R each is selected from H; a C₁-C₆ linear or branched, saturated or unsaturated hydrocarbyl group; or a silyl group SiR'₃ with each R' being independently selected from H; a halogen atom selected from CI, Br, or I; a C₁-C₄ saturated or unsaturated hydrocarbyl group; a C₁-C₄ saturated or unsaturated alkoxy group; or an amino group -NR³R⁴ with each R³ and R⁴ being selected from H or a C₁-C₆ linear or branched, saturated or unsaturated hydrocarbyl group, provided that if R¹ = H, then R² ≠ H or Me. The process to produce the disclosed nitrogen-doped silicon oxide films may include one or more of the following aspects:
- purging the reactor with an inert gas between each introduction step;
- the mono-substituted TSA precursor wherein X is a halogen atom;
- the mono-substituted TSA precursor being (SiH₃)₂N-SiH₂-Cl;
- the mono-substituted TSA precursor being (SiH₃)₂N-SiH₂-Br;
- the mono-substituted TSA precursor being (SiH₃)₂N-SiH₂-I;
- the mono-substituted TSA precursor wherein X is a isocyanate -NCO (i.e., being (SiH₃)₂N-SiH₂-NCO);
- the mono-substituted TSA precursor wherein X is an amino group [-NR¹R²];
- the mono-substituted TSA precursor being (SiH₃)₂N-SiH₂-NiPr₂;
- the mono-substituted TSA precursor being (SiH₃)₂N-SiH₂-NHiPr;
- the mono-substituted TSA precursor being (SiH₃)₂N-SiH₂-NHtBu;
- the mono-substituted TSA precursor not being (SiH₃)₂-N-SiH₂-N(SiH₃)(SiH₂(NHEt)) (i.e., when X=NR¹R² and R¹ is SiH₃ and R² is NHEt);
- the mono-substituted TSA precursor being (SiH₃)₂N-SiH₂-NEt₂;
- the mono-substituted TSA precursor being (SiH₃)₂N-SiH₂ NEtMe;
- the mono-substituted TSA precursor being (SiH₃)₂N-SiH₂ NMe₂;
- the mono-substituted TSA precursor being (SiH₃)₂N-SiH₂ NMeiPr;
- the mono-substituted TSA precursor being (SiH₃)₂N-SiH₂ NEtiPr;
- the mono-substituted TSA precursor wherein X is -N(SiR₃)₂, wherein each R is independently selected from a halogen, H, or a C₁-C₄ alkyl group;
- the mono-substituted TSA precursor being (SiH₃)₂N-SiH₂-N(SiCl₃)₂;
- the mono-substituted TSA precursor being (SiH₃)₂N-SiH₂-N(SiBr₃)₂;
- the mono-substituted TSA precursor being (SiH₃)₂N-SiH₂-N(SiI₃)₂;
- the mono-substituted TSA precursor being (SiH₃)₂N-SiH₂-N(SiH₃)₂;
- the mono-substituted TSA precursor being (SiH₃)₂-N-SiH₂-N(SiH₃)(SiH₂Cl);
- the mono-substituted TSA precursor being (SiH₃)₂-N-SiH₂-N(SiH₃)(SiH₂(NEt₂);
- the mono-substituted TSA precursor being (SiH₃)₂-N-SiH₂-N(SiH₃)(SiH₂(NiPr₂);
- the mono-substituted TSA precursor being (SiH₃)₂-N-SiH₂-N(SiH₃)(SiH₂(NHtBu);
- the mono-substituted TSA precursor being (SiH₃)₂-N-SiH₂-N(SiH₃)(SiH₂OEt);
- the mono-substituted TSA precursor being (SiH₃)₂-N-SiH₂-N(SiH₃)(SiH₂OiPr);
- the mono-substituted TSA precursor being (SiH₃)₂N-SiH₂-N(SiMe₃)₂;
- the mono-substituted TSA precursor being (SiH₃)₂N-SiH₂-NH(SiMe₃);
- the mono-substituted TSA precursor being (SiH₃)₂N-SiH₂-N(SiEt₃)_{2;}
- the mono-substituted TSA precursor being (SiH₃)₂-N-SiH₂-N(SiMe₂Et)₂;
- the mono-substituted TSA precursor being (SiH₃)₂-N-SiH₂-N(SiMe₂iPr)₂;
- the mono-substituted TSA precursor being (SiH₃)₂-N-SiH₂-N(SiMe₂nPr)₂;.
- the mono-substituted TSA precursor wherein X is a N-containing C₄-C₁₀ heterocycle;
- the mono-substituted TSA precursor wherein the N-containing C₄-C₁₀ heterocycle is selected from pyrrolidine, pyrrole, and piperidine;
- the mono-substituted TSA precursor being (SiH₃)₂N-SiH₂-(pyrrolidine);
- the mono-substituted TSA precursor being (SiH₃)₂N-SiH₂-(pyrrole);
- the mono-substituted TSA precursor being (SiH₃)₂N-SiH₂-(piperidine);
- the mono-substituted TSA precursor wherein X is an alkoxy group [-O-R];
- the mono-substituted TSA precursor being (SiH₃)₂N-SiH₂-(OH);
- the mono-substituted TSA precursor being (SiH₃)₂N-SiH₂-(OMe);
- the mono-substituted TSA precursor being (SiH₃)₂N-SiH₂-(OEt);
- the mono-substituted TSA precursor being (SiH₃)₂N-SiH₂-(OiPr);
- the mono-substituted TSA precursor being (SiH₃)₂N-SiH₂-(OnPr);
- the mono-substituted TSA precursor being (SiH₃)₂N-SiH₂-(OtBu);
- the mono-substituted TSA precursor wherein X is -O-SiR₃ and each R is independently selected from H, a halogen, or a C₁-C₄ hydrocarbyl group;
- the mono-substituted TSA precursor being (SiH₃)₂N-SiH₂-(OSiH₃);
- the mono-substituted TSA precursor being (SiH₃)₂N-SiH₂-(OSiCl₃);
- the mono-substituted TSA precursor being (SiH₃)₂N-SiH₂-(OSiBr₃);
- the mono-substituted TSA precursor being (SiH₃)₂N-SiH₂-(OSiI₃);
- the mono-substituted TSA precursor being (SiH₃)₂N-SiH₂-(OSiMe₃);
- the reactant being selected from the group consisting of O₂, O₃, H₂O, H₂O₂, NO, NO₂, a carboxylic acid, an alcohol, a diol, radicals thereof, and combinations thereof; and
- the reactant being selected from the group consisting of N₂, H₂, NH₃, hydrazines (such as N₂H₄, MeHNNH₂, MeHNNHMe), organic amines (such as NMeH₂, NEtH₂, NMe₂H, NEt₂H, NMe₃, NEt₃, (SiMe₃)₂NH), pyrazoline, pyridine, diamines (such as ethylene diamine), radical species thereof, and mixtures thereof.

Also disclosed are silicon- and nitrogen-containing film formation processes. The silicon- and nitrogen-containing films are deposited on a substrate by introducing a vapor of any of the mono-substituted TSA precursors disclosed above and a nitrogen-containing reactant into a reactor containing the substrate. The disclosed processes may include one or more of the following aspects:
- the mono-substituted TSA precursor being (SiH₃)₂N-SiH₂-Cl;
- the mono-substituted TSA precursor being (SiH₃)₂N-SiH₂-Br;
- the mono-substituted TSA precursor being (SiH₃)₂N-SiH₂-I;
- the mono-substituted TSA precursor being (SiH₃)₂N-SiH₂-NMe₂;
- the mono-substituted TSA precursor being (SiH₃)₂N-SiH₂-NMeEt;
- the mono-substituted TSA precursor being (SiH₃)₂N-SiH₂-NEt₂;
- the mono-substituted TSA precursor being (SiH₃)₂N-SiH₂-NiPr₂;
- the mono-substituted TSA precursor being (SiH₃)₂N-SiH₂-NHiPr;
- the mono-substituted TSA precursor being (SiH₃)₂N-SiH₂-NMeiPr;
- the mono-substituted TSA precursor being (SiH₃)₂N-SiH₂-NEtiPr;
- the mono-substituted TSA precursor being (SiH₃)₂N-SiH₂-NHtBu;
- the mono-substituted TSA precursor being (SiH₃)₂N-SiH₂-N(SiCl₃)₂;
- the mono-substituted TSA precursor being (SiH₃)₂N-SiH₂-N(SiBr₃)₂;
- the mono-substituted TSA precursor being (SiH₃)₂N-SiH₂-N(SiI₃)₂;
- the mono-substituted TSA precursor being (SiH₃)₂N-SiH₂-N(SiH₃)₂;
- the mono-substituted TSA precursor being (SiH₃)₂-N-SiH₂-N(SiH₃)(SiH₂Cl);
- the mono-substituted TSA precursor being (SiH₃)₂-N-SiH₂-N(SiH₃)(SiH₂(NEt₂);
- the mono-substituted TSA precursor being (SiH₃)₂-N-SiH₂-N(Si0048₃)(SiH₂(NiPr₂);
- the mono-substituted TSA precursor being (SiH₃)₂-N-SiH₂-N(SiH₃)(SiH₂(NHtBu);
- the mono-substituted TSA precursor being (SiH₃)₂-N-SiH₂-N(SiH₃)(SiH₂OEt);
- the mono-substituted TSA precursor being (SiH₃)₂-N-SiH₂-N(SiH₃)(SiH₂OiPr);
- the mono-substituted TSA precursor being (SiH₃)₂N-SiH₂-N(SiMe₃)₂;
- the mono-substituted TSA precursor being (SiH₃)₂N-SiH₂-NH(SiMe₃);
- the mono-substituted TSA precursor being (SiH₃)₂N-SiH₂-N(SiEt₃)_{2;}
- the mono-substituted TSA precursor being (SiH₃)₂-N-SiH₂-N(SiMe₂Et)₂;
- the mono-substituted TSA precursor being (SiH₃)₂-N-SiH₂-N(SiMe₂iPr)₂;
- the mono-substituted TSA precursor being (SiH₃)₂-N-SiH₂-N(SiMe₂nPr)₂;.
- the nitrogen-containing reactant being selected from the group consisting of ammonia, N₂, N atoms, N radicals, N ions, saturated or unsaturated hydrazine, amines, diamines, ethanolamine, and combinations thereof;
- the nitrogen-containing reactant being ammonia;
- the nitrogen-containing reactant being plasma N₂; and
- the silicon and nitrogen containing film being silicon nitride.

Also disclosed are ALD silicon nitride film formation processes. A silicon nitride film having an etch rate from 0.1% w/w HF normalized to thermally grown silicon oxide in a range from approximately 0.7 to approximately 3.5 is deposited on a substrate by sequentially introducing a vapor of a mono-substituted TSA precursor and a nitrogen-containing reactant into a reactor containing the substrate, the mono-substituted TSA precursor having a formula (SiH₃)₂N-SiH₂-X, wherein X is a halogen atom. The disclosed processes may include one or more of the following aspects:
- the mono-substituted TSA precursor being (SiH₃)₂N-SiH₂-Cl;
- the mono-substituted TSA precursor being (SiH₃)₂N-SiH₂-Br;
- the mono-substituted TSA precursor being (SiH₃)₂N-SiH₂-I;
- the nitrogen-containing reactant being selected from the group consisting of ammonia, N₂, N atoms, N radicals, N ions, saturated or unsaturated hydrazine, amines, diamines, ethanolamine, and combinations thereof;
- the nitrogen-containing reactant being ammonia; and
- the nitrogen-containing reactant being plasma N₂.

### Notation and Nomenclature

Certain abbreviations, symbols, and terms are used throughout the following description and claims, and include:

As used herein, the indefinite article "a" or "an" means one or more than one.

As used herein, the terms "approximately" or "about" mean ±10% of the value stated.

As used herein, the term "independently" when used in the context of describing R groups should be understood to denote that the subject R group is not only independently selected relative to other R groups bearing the same or different subscripts or superscripts, but is also independently selected relative to any additional species of that same R group. For example in the formula MR¹ₓ(NR²R³)₍₄₋ₓ₎, where x is 2 or 3, the two or three R¹ groups may, but need not be identical to each other or to R² or to R³. Further, it should be understood that unless specifically stated otherwise, values of R groups are independent of each other when used in different formulas.

As used herein, the term "hydrocarbyl" means a functional group containing exclusively hydrogen and carbon atoms. The functional group may be saturated (containing only single bonds) or unsaturated (containing double or triple bonds).

As used herein, the term "alkyl group" refers to saturated hydrocarbyl functional groups containing exclusively carbon and hydrogen atoms. Further, the term "alkyl group" refers to linear, branched, or cyclic alkyl groups. Examples of linear alkyl groups include without limitation, methyl groups, ethyl groups, n-propyl groups, n-butyl groups, etc. Examples of branched alkyls groups include without limitation, iso-propyl, t-butyl. Examples of cyclic alkyl groups include without limitation, cyclopropyl groups, cyclopentyl groups, cyclohexyl groups, etc.

As used herein, the term "aryl" refers to aromatic ring compounds where one hydrogen atom has been removed from the ring. As used herein, the term "heterocycle" refers to a cyclic compound that has atoms of at least two different elements as members of its ring.

As used herein, the abbreviation "Me" refers to a methyl group; the abbreviation "Et" refers to an ethyl group; the abbreviation "Pr" refers to any propyl group (i.e., n-propyl or isopropyl); the abbreviation "iPr" refers to an isopropyl group; the abbreviation "Bu" refers to any butyl group (n-butyl, iso-butyl, t-butyl, sec-butyl); the abbreviation "tBu" refers to a tert-butyl group; the abbreviation "sBu" refers to a sec-butyl group; the abbreviation "iBu" refers to an iso-butyl group; the abbreviation "Ph" refers to a phenyl group; the abbreviation "Am" refers to any amyl group (isoamyl, sec-amyl, tert-amyl); the abbreviation "Cy" refers to a cyclic alkyl group (cyclobutyl, cyclopentyl, cyclohexyl, etc.); and the abbreviation "^{R}amd" refers to an R-N-C(Me)-N-R amidinate ligand, with R being an alkyl group (e.g., ^{iPr}amd is iPr-N-C(Me)-N-iPr).

As used herein, the acronym "SRO" stands for a Strontium Ruthenium Oxide film; the acronym "HCDS" stands for hexachlorodisilane; the acronym "PCDS" stands for pentachlorodisilane; the acronym "OCTS" stands for n-octyltrimethoxysilane; the acronym "TSA" stands for trisilylamine or N(SiH₃)₃; the acronym "DSA" stands for disilylamine or HN(SiH₃)₂; and the acronym "PTFE" stands for Polytetrafluoroethylene.

As used herein, the acronym "LCD-TFT" stands for liquid-crystal display-thin-film transistor; the acronym "MIM" stands for Metal-insulator-metal; the acronym "DRAM" stands for dynamic random-access memory; the acronym "FeRAM" stands for Ferroelectric random-access memory; the acronym "OLED" stands for organic light-emitting diode; the acronym "sccm" stands for standard cubic centimeter; and the acronym "GCMS" stands for Gas Chromatography-Mass Spectrometry.

As used herein, the terms "sequential" or "sequentially" means consecutive, or following one another. With reference to the claimed process, the term "sequentially" refers to the atomic layer deposition process of repetitively reacting a precursor with a substrate to form a reacted layer followed by reacting a reactant with the reacted layer. This may be accomplished either by separate and sequential injection of the precursor followed by the reactant or by rotating the substrate below, or showerhead above, a substrate so that the portions of the substrate are sequentially contacted by the precursor then (sequentially) the reactant.

The standard abbreviations of the elements from the periodic table of elements are used herein. It should be understood that elements may be referred to by these abbreviations (e.g., Si refers to silicon, N refers to nitrogen, O refers to oxygen, C refers to carbon, etc.).

Please note that the films or layers deposited, such as silicon oxide, are listed throughout the specification and claims without reference to their proper stoichoimetry (i.e., SiO₂). The layers may include pure (Si) layers, silicide (MₒSiₚ) layers, carbide (SiₒCₚ) layers, nitride (SiₖNₗ) layers, oxide (SiₙOₘ) layers, or mixtures thereof; wherein M is an element and k, l, m, n, o, and p inclusively range from 1 to 6. For instance, cobalt silicide is CoₖSiₗ, where k and I each range from 0.5 to 5. Similarly, any referenced layers may also include a Silicon oxide layer, SiₙOₘ, wherein n ranges from 0.5 to 1.5 and m ranges from 1.5 to 3.5. More preferably, the silicon oxide layer is SiO₂ or SiO₃. The silicon oxide layer may be a silicon oxide based dielectric material, such as organic based or silicon oxide based low-k dielectric materials such as the Black Diamond II or III material by Applied Materials, Inc. Alternatively, any referenced silicon-containing layer may be pure silicon. Any silicon-containing layers may also include dopants, such as B, C, P, As and/or Ge.

Any and all ranges recited herein are inclusive of their endpoints (i.e., x=1 to 4 includes x=1, x=4, and x=any number in between), irrespective of whether the term "inclusively" is used.

### Brief Description of the Drawings

For a further understanding of the nature and objects of the present invention, reference should be made to the following detailed description, taken in conjunction with the accompanying figure wherein:
**FIG. 1** is a side view of one embodiment of the Si-containing film forming composition delivery device 1;
**FIG. 2** is a side view of a second embodiment of the Si-containing film forming composition delivery device **1;**
**FIG 3** is a diagram of the Picosun R200 PEALD 8" deposition tool used to perform the depositions in Examples 4-6;
**FIG 4** is a graph the ALD growth rate of silicon oxide films as a function of the number of precursor pulses using the precursor (SiH₃)₂N-SiH₂-NiPr₂ (TSA-NiPr₂);
**FIG 5** is a graph of the ALD growth rate of silicon oxide thin film as a function of the temperature using the precursor TSA-NiPr₂;
**FIG 6** is a graph the ALD growth rate of silicon oxide films as a function of the number of precursor pulses and the temperature using the precursor (SiH₃)₂N-SiH₂-N(SiH₃)₂;
**FIG 7** is a graph the ALD growth rate of silicon oxide films as a function of the number of precursor pulses using the precursor (SiH₃)₂N-SiH₂-NEt₂ (TSA-NEt₂);
**FIG 8** is a graph the ALD growth rate of silicon oxide films as a function of substrate temperature using the precursor (SiH₃)₂N-SiH₂-Cl (TSA-Cl);
**FIG 9** is a X-ray Photoelectron Spectroscopy (XPS) graph showing the film composition of a film deposited by thermal low vapor pressure CVD using TSA-CI and NH₃ at 1 torr, 550°C, and a precursor to NH₃ ratio of 1:20. Cl was below the detection limit of the analyser (< ∼ 1%). The deposition rate was 10 Ang/min and the Refractive Index of the obtained film was 2.1. For comparison, films obtained in the same conditions with TSA had a RI of 2.2 (silicon rich) and a similar deposition rate;
**FIG 10** is a graph demonstrating the comparative wet etch rate of silicon oxide films deposited using 25 W plasma and 100 W plasma normalized against thermally grown silicon oxide (Th-Ox);
**FIGS 11** **a and b** are Scanning Electron Microscope (SEM) images showing the SiN film obtained by PE-ALD with TSA-CI / N₂ plasma at 250°C, indicating a high step coverage in a 5:1 high aspect ratio structure. The pictures are taken at the top and middle/bottom of the trench structure;
**FIGS 12** **a and b** are SEM images showing the silicon oxide film obtained by spatial ALD with TSA-NiPr₂ / O₂ plasma at 60 cycles per minute, 100°C, indicating a perfect step coverage in a 22:1 high aspect ratio structure. A clear underlying Ta₂O₅ layer was added for contrast enhancement. The pictures are taken at the top and bottom of the trench structure; and
**FIGS 13** **a and b** are graphs showing the thermal stability of TSA-NiPr₂ and TSA-NEt₂ [(H₃Si)₂-N-SiH₂-NEt₂], respectively, by thermal screening unit. In such a measurement, the pressure of a sealed sample is measured continuously during 24 hours at a set temperature (here 65°C). A lack of significant pressure change indicates product stability. The observed P oscillation are insignificant here and associated with minute T variations.

### Description of the Preferred Embodiments

Disclosed are Si-containing film forming compositions comprising mono-substituted TSA precursors having a Si-C bond free backbone and a single chemically functionalized site to enable a high surface reactivity. Mono-substituted TSA precursors having a number of silicon atoms higher than 1, and preferably higher than 2, without a direct Si-C bond, and being polar molecules may have an enhanced reactivity to a substrate surface to enable a fast deposition rate. The mono-substituted TSA precursors have the general formula:

(SiH₃)₂N-SiH₂-X

wherein X is selected from a halogen atom selected from CI, Br or I; an isocyanato group [-NCO]; an amino group [-NR¹R²]; a N-containing C₄-C₁₀ saturated or unsaturated heterocycle; or an alkoxy group -O-R; each R¹, R² and R selected from a H; a silyl group (SiR'₃); or a C₁-C₆ linear or branched, saturated or unsaturated hydrocarbyl group; with each R' being independently selected from H; a halogen atom selected from CI, Br, or I; a C₁-C₄ saturated or unsaturated hydrocarbyl group; a C₁-C₄ saturated or unsaturated alkoxy group; or an amino group [-NR³R⁴], with each R³ and R⁴ being independently selected from H or a C₁-C₆ linear or branched, saturated or unsaturated hydrocarbyl group; provided that if R¹ = H, then R² ≠ H, Me, or Et. The C₁-C₆ linear or branched, saturated or unsaturated hydrocarbyl group may contain amines or ethers. Alternatively, R¹ and R² may be independently selected from Me, Et, iPr, nPr, tBu, nBu, and secBu. According to the invention as claimed in the appended claims X is an amino group [-NR2] and each R is independently selected from the group consisting of H; a C1 -C6 hydrocarbyl group.

Applicants believe that the disclosed Si-containing film forming compositions are particularly well suited for flowable CVD processes because the mono-substituted TSA precursors contain little to no carbon. Additionally, the mono-substituted TSA precursors have a lower vapor pressure than TSA and, as a result, may more easily condense and provide a higher deposition rate. Finally, the mono-substituted TSA structure is close to that of oligomers formed during flowable process.

The disclosed mono-substituted TSA precursors contain two or three hydrogen atoms directly bonded to each Si atom. These Si-H bonds help increase the volatility of the precursor, which is important for vapor deposition processes.

When X is a halide, exemplary Si-containing film forming compositions include (SiH₃)₂-N-SiH₂Cl, (SiH₃)₂-N-SiH₂Br, or (SiH₃)₂-N-SiH₂I. Halides are known for their high reactivity. Applicants believe that the halide on the disclosed mono-substituted TSA precursors may help to improve volatility and the deposition rate as compared to the non-halogenated analogs. These compositions may be synthesized according to the reaction: SnX₄ + N(SiH₃)₃ → N(SiH₃)₂(SiH₂X) + SnX₂↓ + HX, wherein X is CI, Br, or I (see J. Chem. Soc. Dalton Trans. 1975, p.1624). Alternatively, dihalosilane [SiH₂X₂, wherein X is CI, Br, or I] and monohalosilane [SiH₃X, wherein X is CI, Br, or I] may be introduced continuously in the gas phase in a 1/20 to ¼ ratio and at room temperature with 400 sccm of NH₃ in a flow-through tubular reactor as described by Miller in U.S. Pat. No. US 8,669,387. The reaction of NH₃ with 2 equivalents of monohalosilane produces mostly disilylamine (DSA). DSA then reacts with the dihalosilane to form (SiH₃)₂-N-SiH₂X and HX, wherein X is CI, Br, or I. One of ordinary skill in the art would recognize that the reaction may take place in one or two steps (first forming DSA from the monohalosilane and NH₃ and second adding dihalosilane) or in one step (combining the monohalosilane, dichlorosilane, and NH₃ in one step).

When X is an isocyanato group [-NCO], exemplary Si-containing film forming compositions include (SiH₃)₂-N-SiH₂(NCO). This composition may be synthesized using dehydrogenerative coupling according to the method disclosed by Taniguchi et al. in Angewandte Communications, Angew. Chem. Int. Ed. 2013, 52, 1-5. More particularly, (SiH₃)₃N may be reacted with urea (NH₂CONH₂) to form (SiH₃)₂-N-SiH₂(NCO)+H₂ in the presence of gold nanoparticles supported on alumina.

According to the invention as claimed in the appended claims X is an amino group [-NR¹R²], exemplary Si-containing film forming compositions according to the invention as claimed in the appended claims include (SiH₃)₂-N-SiH₂(NMe₂), (SiH₃)₂-N-SiH₂(NMeEt), (SiH₃)₂-N-SiH₂(NEt₂), (SiH₃)₂-N-SiH₂(NiPr₂), (SiH₃)₂-N-SiH₂(NHiPr), (SiH₃)₂-N-SiH₂(NMeiPr), (SiH₃)₂-N-SiH₂(NEtiPr), (SiH₃)₂-N-SiH₂(NHtBu). The amino group may also help increase thermal stability. The amino group may also help incorporate N and C atoms into the resulting film, which may make the resulting layer more resistant to any subsequent etching processes.

When R¹ and R² form a cyclic nitrogen-containing heterocycle, Applicants believe that the resulting heterocycle forms a leaving group that may be easily detached from the mono-substituted TSA precursor, resulting in less carbon contamination of the resulting film as compared to the acyclic dialkyl amino groups.

One of ordinary skill in the art will recognize that the volatility provided by the Si-H bonds balances with the thermal stability provided by the amino groups. Applicants believe that at least (H₃Si)₂-N-SiH₂-NEt₂, (H₃Si)₂-N-SiH₂-SiH₂-NiPr₂, and (H₃Si)₂-N-SiH₂-N(SiH₃)₂ successfully balance those competing characteristics to produce exceptional vapor deposition precursors. As will be shown in the Examples that follow, the qualities of the resulting Si-containing films are improved over those disclosed in the prior art.

The amino-substituted Si-containing film forming compositions may be synthesized similarly to the halo-substituted Si-containing film forming compositions disclosed above. More particularly, 200 sccm of monohalosilane and 50 sccm of dihalosilane may be introduced continuously in the gas phase and at room temperature with 400 sccm of NH₃ in a flow-through tubular reactor as described in US 8,669,387, forming a stream consisting of various silylamines and ammonium halide, from which (SiH₃)₂-N-SiH₂[N(SiH₃)₂] may be isolated by methods easily derived by a person having ordinary skill in the art, such as a method of fractional distillation.

More particularly, (SiH₃)₂-N-SiH₂[N(SiMe₃)₂] may be synthesized from the reaction of SiMe₃-NH-SiMe₃ with tBuLi --> (Me₃Si)₂NLi, and reaction of (Me₃Si)₂NLi with (SiH₃)₂-N-SiH₂-Cl --> (SiH₃)₂-N-SiH₂-N(SiMe₃)₂ + LiCl).

Similarly, (SiH₃)₂-N-SiH₂-NH(SiMe₃) may be synthesized from the reaction of SiMe₃-NH-SiMe₃ + (SiH₃)₂-N-SiH₂-Cl --> (SiH₃)₂-N-SiH₂-NH-SiMe₃ + Me₃SiCl.

(SiH₃)₂-N-SiH₂-N(SiH₃)(SiH₂X) may be synthesized from the reaction of (SiH₃)₂-N-SiH₂-N(SiH₃)₂ with SnX₃, wherein X is Cl, Br_{.} or I (see J. Chem. Soc. Dalton Trans. 1975, p. 1624). Further substitution of (SiH₃)₂-N-SiH₂-N(SiH₃)₂ may be achieved by increasing the reaction time and/or adjusting the stoichiometry.

(SiH₃)₂-N-SiH₂-N(SiH₃)(SiH₂(NEt₂)) may be synthesized from the reaction of (SiH₃)₂-N-SiH₂-N(SiH₃)(SiH₂X) and HNEt₂. Further substitution of (SiH₃)₂-N-SiH₂-N(SiH₃)(SiH₂(NEt₂)) may be achieved by increasing the reaction time and/or adjusting the stoichiometry.

(SiH₃)₂-N-SiH₂-N(SiH₃)(SiH₂(NiPr₂)) may be synthesized from the reaction of (SiH₃)₂-N-SiH₂-N(SiH₃)(SiH₂X) and HNiPr₂. Further substitution of (SiH₃)₂-N-SiH₂-N(SiH₃)(SiH₂(NiPr₂)) may be achieved by increasing the reaction time and/or adjusting the stoichiometry.

(SiH₃)₂-N-SiH₂-N(SiH₃)(SiH₂(NHtBu)) may be synthesized from the reaction of (SiH₃)₂-N-SiH₂-N(SiH₃)(SiH₂X) and H₂NtBu. Please note that a similar reaction using H₂NEt may produce low yields of (SiH₃)₂-N-SiH₂-N(SiH₃)(SiH₂(NHEt)).

(SiH₃)₂-N-SiH₂-N(SiH₃)(SiH₂(OEt)) may be synthesized from the reaction of (SiH₃)₂-N-SiH₂-N(SiH₃)(SiH₂X) and Ethanol (EtOH) in the presence of a HCl scavenger, like NEt₃ or pyridine.

(SiH₃)₂-N-SiH₂-N(SiH₃)(SiH₂(OiPr)) may be synthesized from the reaction of (SiH₃)₂-N-SiH₂-N(SiH₃)(SiH₂X) and isopropanol (iPrOH) in the presence of a HCl scavenger, like NEt₃ or pyridine.

When X is a N-containing C₄-C₁₀ saturated or unsaturated heterocycle, exemplary Si-containing film forming compositions include (SiH₃)₂-N-SiH₂-pyrrolidine, (SiH₃)₂-N-SiH₂-pyrrole, or (SiH₃)₂-N-SiH₂-piperidine. Alternatively, the N-containing C₄-C₁₀ saturated or unsaturated heterocycle may also contain hetero-elements, such as P, B, As, Ge, and/or Si.

When X is an alkoxy group, exemplary Si-containing film forming compositions include (SiH₃)₂-N-SiH₂(OEt), (SiH₃)₂-N-SiH₂(OiPr), (SiH₃)₂N-SiH₂-OSiMe₃, (SiH₃)₂-N-SiH₂-OSiMe₂OEt, or (SiH₃)₂-N-SiH₂-OSiHMe₂.

N(SiH₃)₂(SiH₂OEt) may also be synthesized from (SiH₃)₂-N-SiH₂Cl and EtOH in the presence of an acid scavenger, such as Et₃N or pyridine.

N(SiH₃)₃ + EtOH → N(SiH₃)₂(SiH₂OEt).

Preferably, the disclosed Si-containing film forming compositions have suitable properties for vapor depositions methods, such as high vapor pressure, low melting point (preferably being in liquid form at room temperature), low sublimation point, and/or high thermal stability.

To ensure process reliability, the disclosed Si-containing film forming compositions may be purified by continuous or fractional batch distillation prior to use to a purity ranging from approximately 95% w/w to approximately 100% w/w, preferably ranging from approximately 98% w/w to approximately 100% w/w. One of ordinary skill in the art will recognize that the purity may be determined by H NMR or gas or liquid chromatography with mass spectrometry. The Si-containing film forming composition may contain any of the following impurities: halides (X₂), trisilylamine, monohalotrisilylamine, dihalotrisilylamine, SiH₄, SiH₃X, SnX₂, SnX₄, HX, NH₃, NH₃X, monochlorosilane, dichlorosilane, alcohol, alkylamines, dialkylamines, alkylimines, THF, ether, pentane, cyclohexane, heptanes, or toluene, wherein X is CI, Br, or I. Preferably, the total quantity of these impurities is below 0.1% w/w. The purified composition may be produced by recrystallisation, sublimation, distillation, and/or passing the gas or liquid through a suitable adsorbent, such as a 4A molecular sieve or a carbon-based adsorbent (e.g., activated carbon).

The concentration of each solvent (such as THF, ether, pentane, cyclohexane, heptanes, and/or toluene), in the purified mono-substituted TSA precursor composition may range from approximately 0% w/w to approximately 5% w/w, preferably from approximately 0% w/w to approximately 0.1 % w/w. Solvents may be used in the precursor composition's synthesis. Separation of the solvents from the precursor composition may be difficult if both have similar boiling points. Cooling the mixture may produce solid precursor in liquid solvent, which may be separated by filtration. Vacuum distillation may also be used, provided the precursor composition is not heated above approximately its decomposition point.

The disclosed Si-containing film forming composition contains less than 5% v/v, preferably less than 1% v/v, more preferably less than 0.1% v/v, and even more preferably less than 0.01% v/v of any of its mono-, dual- or tris-, analogs or other reaction products. This embodiment may provide better process repeatability. This embodiment may be produced by distillation of the Si-containing film forming composition.

Purification of the disclosed Si-Containing film forming composition may also produce concentrations of trace metals and metalloids ranging from approximately 0 ppbw to approximately 500 ppbw, and more preferably from approximately 0 ppbw to approximately 100 ppbw. These metal or metalloid impurities include, but are not limited to, Aluminum(AI), Arsenic(As), Barium(Ba), Beryllium(Be), Bismuth(Bi), Cadmium(Cd), Calcium(Ca), Chromium(Cr), Cobalt(Co), Copper(Cu), Gallium(Ga), Germanium(Ge), Hafnium(Hf), Zirconium(Zr), Indium(In), Iron(Fe), Lead(Pb), Lithium(Li), Magnesium(Mg), Manganese(Mn), Tungsten(W), Nickel(Ni), Potassium(K), Sodium(Na), Strontium(Sr), Thorium(Th), Tin(Sn), Titanium(Ti), Uranium(U), Vanadium(V) and Zinc(Zn). The concentration of X (where X = CI, Br, I) in the purified mono-substituted TSA precursor composition may range between approximately 0 ppmw and approximately 100 ppmw and more preferably between approximately 0 ppmw to approximately 10 ppmw.

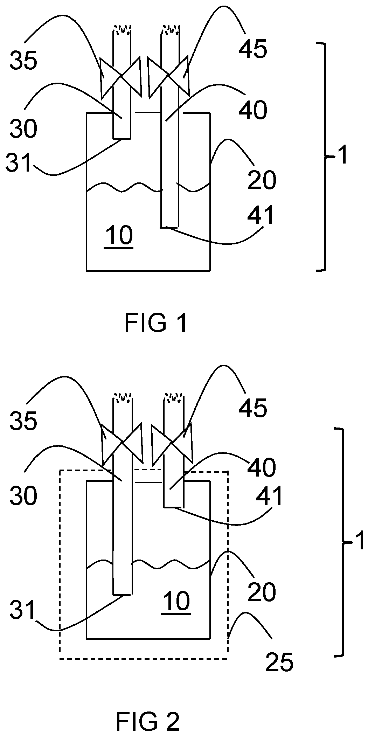

The disclosed Si-containing film forming compositions may be delivered to a semiconductor processing tool by the disclosed Si-containing film forming composition delivery devices. **FIGS. 1 and 2** show two embodiments of the disclosed delivery devices **1.**

**FIG. 1** is a side view of one embodiment of the Si-containing film forming composition delivery device **1.** In **FIG. 1****,** the disclosed Si-containing film forming composition **10** are contained within a container **20** having two conduits, an inlet conduit **30** and an outlet conduit **40.** One of ordinary skill in the precursor art will recognize that the container **20,** inlet conduit **30,** and outlet conduit **40** are manufactured to prevent the escape of the gaseous form of the Si-containing film forming composition **10,** even at elevated temperature and pressure.

Suitable valves include spring-loaded or tied diaphragm valves. The valve may further comprise a restrictive flow orifice (RFO). The delivery device should be connected to a gas manifold and in an enclosure. The gas manifold should permit the safe evacuation and purging of the piping that may be exposed to air when the delivery device is replaced so that any residual amount of the pyrophoric material does not react. The enclosure should be equipped with sensors and fire control capability to control the fire in the case of a pyrophoric material release, such as SiH₄. The gas manifold should also be equipped with isolation valves, vacuum generators, and permit the introduction of a purge gas at a minimum.

The delivery device must be leak tight and be equipped with valves that do not permit escape of even minute amounts of the material. The delivery device fluidly connects to other components of the semiconductor processing tool, such as the gas cabinet disclosed above, via valves **35** and **45.** Preferably, the delivery device **20,** inlet conduit **30,** valve **35,** outlet conduit **40,** and valve **45** are made of 316L EP or 304 stainless steel. However, one of ordinary skill in the art will recognize that other non-reactive materials may also be used in the teachings herein and that any corrosive Si-containing film forming composition **10** may require the use of more corrosion-resistant materials, such as Hastelloy or Inconel.

In **FIG. 1****,** the end **31** of inlet conduit **30** is located above the surface of the Si-containing film forming composition **10,** whereas the end **41** of the outlet conduit **40** is located below the surface of the Si-containing film forming composition **10.** In this embodiment, the Si-containing film forming composition **10** is preferably in liquid form. An inert gas, including but not limited to nitrogen, argon, helium, and mixtures thereof, may be introduced into the inlet conduit **30.** The inert gas pressurizes the delivery device **20** so that the liquid Si-containing film forming composition **10** is forced through the outlet conduit **40** and to components in the semiconductor processing tool (not shown). The semiconductor processing tool may include a vaporizer which transforms the liquid Si-containing film forming composition **10** into a vapor, with or without the use of a carrier gas such as helium, argon, nitrogen or mixtures thereof, in order to deliver the vapor to a chamber where a wafer to be repaired is located and treatment occurs in the vapor phase. Alternatively, the liquid Si-containing film forming composition **10** may be delivered directly to the wafer surface as a jet or aerosol.

**FIG. 2** is a side view of a second embodiment of the Si-containing film forming composition delivery device **1.** In **FIG. 2****,** the end **31** of inlet conduit **30** is located below the surface of the Si-containing film forming composition **10,** whereas the end **41** of the outlet conduit **40** is located above the surface of the Si-containing film forming composition **10.** **FIG. 2****,** also includes an optional heating element **25,** which may increase the temperature of the Si-containing film forming composition **10.** The Si-containing film forming composition **10** may be in solid or liquid form. An inert gas, including but not limited to nitrogen, argon, helium, and mixtures thereof, is introduced into the inlet conduit **30.** The inert gas flows through the Si-containing film forming composition **10** and carries a mixture of the inert gas and vaporized Si-containing film forming composition **10** to the outlet conduit **40** and to the components in the semiconductor processing tool.

Both **FIGS. 1 and 2** include valves **35** and **45.** One of ordinary skill in the art will recognize that valves **35** and **45** may be placed in an open or closed position to allow flow through conduits **30** and **40,** respectively. Either delivery device **1** in **FIGS. 1 or 2****,** or a simpler delivery device having a single conduit terminating above the surface of any solid or liquid present, may be used if the Si-containing film forming composition **10** is in vapor form or if sufficient vapor pressure is present above the solid/liquid phase. In this case, the Si-containing film forming composition **10** is delivered in vapor form through the conduit **30** or **40** simply by opening the valve **35** in **FIG. 1** or **45** in **FIG. 2****,** respectively. The delivery device **1** may be maintained at a suitable temperature to provide sufficient vapor pressure for the Si-containing film forming composition **10** to be delivered in vapor form, for example by the use of an optional heating element **25.**

While **FIGS. 1 and 2** disclose two embodiments of the Si-containing film forming composition delivery device **1,** one of ordinary skill in the art will recognize that the inlet conduit **30** and outlet conduit **40** may both be located above or below the surface of the Si-containing film forming composition **10** without departing from the disclosure herein. Furthermore, inlet conduit **30** may be a filling port. Finally, one of ordinary skill in the art will recognize that the disclosed Si-containing film forming compositions may be delivered to semiconductor processing tools using other delivery devices, such as the ampoules disclosed in WO 2006/059187 to Jurcik et al.*,* without departing from the teachings herein.

The disclosed Si-containing film forming compositions may be suitable for the deposition of Si-containing films by various ALD or CVD processes and may have the following advantages:
- liquid at room temperature or having a melting point lower than 50°C;
- thermally stable to enable proper distribution (gas phase or direct liquid injection) without particles generation; and/or
- suitable reactivity with the substrate to permit a wide self-limited ALD window, allowing deposition of a variety of Si -containing films.

Silicon nitride and silicon oxide containing films (referred to as SiOₓN_{y}) may be deposited by CVD or ALD using one or a combination of reactants selected from the group comprising of N₂, H₂, NH₃, O₂, H₂O, H₂O₂, O₃, NO, NO₂, N₂O, a carboxylic acid, an alcohol, a diol, hydrazines (such as N₂H₄, MeHNNH₂, MeHNNHMe), organic amines (such as NMeH₂, NEtH₂, NMe₂H, NEt₂H, NMe₃, NEt₃, (SiMe₃)₂NH), pyrazoline, pyridine, diamines (such as ethylene diamine), a combination thereof, and the plasma product thereof.

Ternary or quarternary films may be deposited using the Si-containing film forming compositions with one or several other precursors containing elements selected from As, B, P, Ga, Ge, Sn, Sb, Al, In, or a transition metal precursor, and possibly one or more reactant listed above. Typical precursors that may be used along with the disclosed Si-containing film forming compositions are selected from the families of :
- Metal Halides (for example, TiCl₄, TiI₄, TaCl₅, HfCl₄, ZrCl₄, AlCl₃, NbF₅, *etc.);*
- Alkyls (Al, Ge, Ga, In, Sb, Sn, Zn), such as trimethylaluminum, diethylzinc, triethylgalium;
- Hydrides (GeH₄, alanes, *etc.);*
- Alkylamides (metals of group IV and V transition metals);
- Imido group (metals of group V and VI);
- Alkoxides (metals of group IV, V);
- Cyclopentadienyls (Ru, Co, Fe, Group IV transition metals, lanthanides *etc.);*
- Carbonyls (ex: Ru, Co, Fe, Ni);
- Amidinates and guanidinates (ex : Co, Mn, Ni, Cu, Sc, *etc.);*
- Beta-diketonates (ex : Sc, Cu, lanthanides);
- Beta-diketoimines (Cu, Ni, Co, *etc.);*
- Bis-trialkylsilylamides (Ni, Co, Fe, *etc.);*
- Oxo groups (RuO₄, WOCl₄, PO(OEt)₃, AsO(OEt)₃, *etc.);*
- Or heteroleptic molecules having a combination of the above ligands.

The disclosed Si-containing film forming compositions may also be used in conjunction with another silicon source, such as a halosilane (possibly selected from SiH₃Cl, SiH₂Cl₂, SiHCl₃, SiCl₄, SiBr₄, SiI₄, SiHI₃, SiH₂I₂, SiH₃I, SiF₄), a polysilane SiHₓH₂ₓ₊₂, or a cyclic polysilane SiHₓH₂ₓ, a halo-polysilane (SiₓCl₂ₓ₊₂, SiₓH_{y}Cl_{2x+2-y}, such as HCDS, OCTS, PCDS, MCDS (monochlorodisilane or Si₂H₅Cl), DCDS (dichlorodisilane or Si₂H₄Cl₂), or a carbosilane having a Si-(CH₂)ₙ-Si backbone, with n= 1 or 2.

Also disclosed are methods of using the disclosed Si-containing film forming compositions for vapor deposition methods, including various CVD and ALD methods. The disclosed methods provide for the use of the disclosed Si-containing film forming compositions for deposition of silicon-containing films, preferably silicon nitride (SiN) films, silicon-oxide (SiO) films, and nitrogen doped silicon-oxide films. The disclosed methods may be useful in the manufacture of semiconductor, photovoltaic, LCD-TFT, flat panel type devices, refractory materials, or aeronautics.

The disclosed methods for forming a silicon-containing layer on a substrate include: placing a substrate in a reactor, delivering into the reactor a vapor including the Si-containing film forming composition, and contacting the vapor with the substrate (and typically directing the vapor to the substrate) to form a silicon-containing layer on the surface of the substrate. Alternatively, the substrate is moved to the chamber that contains the precursor vapors (spatial ALD) and then moved to another area that contains the reactant. Other physical treatment steps may be carried in between the exposure to precursor and reactants, such as a flash anneal, a UV cure, *etc.*

The methods may include forming a bimetal-containing layer on a substrate using the vapor deposition process and, more specifically, for deposition of SiMOₓ films wherein x is 4 and M is Ti, Hf, Zr, Ta, Nb, V, Al, Sr, Y, Ba, Ca, As, B, P, Sb, Bi, Sn, lanthanides (such as Er), or combinations thereof. The disclosed methods may be useful in the manufacture of semiconductor, photovoltaic, LCD-TFT, or flat panel type devices. An oxygen source, such as O₃, O₂, H₂O, NO, H₂O₂, acetic acid, formalin, para-formaldehyde, alcohol, a diol, oxygen radicals thereof, and combinations thereof, but preferably O₃ or plasma treated O₂, may also be introduced into the reactor.

The disclosed Si-containing film forming compositions may be used to deposit silicon-containing films using any deposition methods known to those of skill in the art. Examples of suitable deposition methods include chemical vapor deposition (CVD) or atomic layer deposition (ALD). Exemplary CVD methods include thermal CVD, pulsed CVD (PCVD), low pressure CVD (LPCVD), subatmospheric CVD (SACVD) or atmospheric pressure CVD (APCVD), hot-wire CVD (HWCVD, also known as cat-CVD, in which a hot wire serves as an energy source for the deposition process), radicals incorporated CVD, plasma enhanced CVD (PECVD) including but not limited to flowable CVD (FCVD), and combinations thereof. Exemplary ALD methods include thermal ALD, plasma enhanced ALD (PEALD), spatial isolation ALD, hot-wire ALD (HWALD), radicals incorporated ALD, and combinations thereof. Super critical fluid deposition may also be used. The deposition method is preferably FCVD, ALD, PE-ALD, or spatial ALD in order to provide suitable step coverage and film thickness control.

The Si-containing film forming compositions are delivered into a reactor in vapor form by conventional means, such as tubing and/or flow meters. The vapor form of the compositions may be produced by vaporizing the neat or blended composition solution through a conventional vaporization step such as direct vaporization, distillation, by bubbling. The composition may be fed in liquid state to a vaporizer where it is vaporized before it is introduced into the reactor. Prior to vaporization, the composition may optionally be mixed with one or more solvents. The solvents may be selected from the group consisting of toluene, ethyl benzene, xylene, mesitylene, decane, dodecane, octane, hexane, pentane, or others. The resulting concentration may range from approximately 0.05 M to approximately 2 M.

Alternatively, the Si-containing film forming compositions may be vaporized by passing a carrier gas into a container containing the precursor or by bubbling of the carrier gas into the precursor. The composition may optionally be mixed in the container with one or more solvents. The solvents may be selected from the group consisting of toluene, ethyl benzene, xylene, mesitylene, decane, dodecane, octane, hexane, pentane, or others. The resulting concentration may range from approximately 0.05 M to approximately 2 M. The carrier gas may include, but is not limited to, Ar, He, or N₂, and mixtures thereof. Bubbling with a carrier gas may also remove any dissolved oxygen present in the neat or blended composition. The carrier gas and composition are then introduced into the reactor as a vapor.

If necessary, the container may be heated to a temperature that permits the Si-containing film forming composition to be in liquid phase and to have a sufficient vapor pressure. The container may be maintained at temperatures in the range of, for example, 0 to 150°C. Those skilled in the art recognize that the temperature of the container may be adjusted in a known manner to control the amount of composition vaporized. The temperature is typically adjusted to reach a vapor pressure of 0,1-100 torr, preferably around 1-20 torr.

The vapor of the Si-containing film forming composition is generated and then introduced into a reaction chamber containing a substrate. The temperature and the pressure in the reaction chamber and the temperature of the substrate are held at conditions suitable for vapor deposition of at least part of the mono-substituted TSA precursor onto the substrate. In other words, after introduction of the vaporized composition into the reaction chamber, conditions within the reaction chamber are adjusted such that at least part of the vaporized precursor is deposited onto the substrate to form the Si-containing layer. One of ordinary skill in the art will recognize that "at least part of the vaporized compound is deposited" means that some or all of the compound reacts with or adheres to the substrate. Herein, a reactant may also be used to help in formation of the Si-containing layer. Furthermore, the Si-containing layer may be cured by UV and Electron beam.

The reaction chamber may be any enclosure or chamber of a device in which deposition methods take place, such as, without limitation, a parallel-plate type reactor, a cold-wall type reactor, a hot-wall type reactor, a single-wafer reactor, a multi-wafer reactor, or other such types of deposition systems. All of these exemplary reaction chambers are capable of serving as an ALD or CVD reaction chamber. The reaction chamber may be maintained at a pressure ranging from about 0.5mTorr to about 20Torr for all ALD and subatmospheric CVD. Subatmospheric CVD and atmospheric CVD pressures may range up to 760Torr (atmosphere). In addition, the temperature within the reaction chamber may range from about 0°C to about 800°C. One of ordinary skill in the art will recognize that the temperature may be optimized through mere experimentation to achieve the desired result.

The temperature of the reactor may be controlled by either controlling the temperature of the substrate holder or controlling the temperature of the reactor wall. Devices used to heat the substrate are known in the art. The reactor wall is heated to a sufficient temperature to obtain the desired film at a sufficient growth rate and with desired physical state and composition. A non-limiting exemplary temperature range to which the reactor wall may be kept from approximately 20°C to approximately 800°C. When a plasma deposition process is utilized, the deposition temperature may range from approximately 0°C to approximately 550°C. Alternatively, when a thermal process is performed, the deposition temperature may range from approximately 200°C to approximately 800°C.

Alternatively, the substrate may be heated to a sufficient temperature to obtain the desired silicon-containing film at a sufficient growth rate and with desired physical state and composition. A non-limiting exemplary temperature range to which the substrate may be heated includes from 50°C to 600°C. Preferably, the temperature of the substrate remains less than or equal to 500°C.

Alternatively, the ALD process may be carried at a substrate temperature being set below a self-decomposition of the precursor. One of ordinary skill in the art would recognize how to determine the self-decomposition temperature of the precursor.

The reactor contains one or more substrates onto which the films will be deposited. A substrate is generally defined as the material on which a process is conducted. The substrates may be any suitable substrate used in semiconductor, photovoltaic, flat panel, or LCD-TFT device manufacturing. Examples of suitable substrates include wafers, such as silicon, silica, glass, plastic or GaAs wafers. The wafer may have one or more layers of differing materials deposited on it from a previous manufacturing step. For example, the wafers may include silicon layers (crystalline, amorphous, porous, *etc*.), silicon oxide layers, silicon nitride layers, silicon oxy nitride layers, carbon doped silicon oxide (SiCOH) layers, photoresist layers, anti-reflective layers, or combinations thereof. Additionally, the wafers may include copper layers or noble metal layers (e.g. platinum, palladium, rhodium, or gold). The layers may include oxides which are used as dielectric materials in MIM, DRAM, STT RAM, PC-RAM or FeRam technologies (e.g., ZrO₂ based materials, HfO₂ based materials, TiO₂ based materials, rare earth oxide based materials, ternary oxide based materials such as strontium ruthenium oxide (SRO), *etc*.) or from nitride-based films (e.g., TaN) that are used as an oxygen barrier between copper and the low-k layer. The wafers may include barrier layers, such as manganese, manganese oxide, *etc.* Plastic layers, such as poly(3,4-ethylenedioxythiophene)poly(styrenesulfonate) (PEDOT:PSS) may also be used. The layers may be planar or patterned. For example, the layer may be a patterned photoresist film made of hydrogenated carbon, for example CHₓ, wherein x is greater than zero. The disclosed processes may deposit the silicon-containing layer directly on the wafer or directly on one or more than one (when patterned layers form the substrate) of the layers on top of the wafer. Furthermore, one of ordinary skill in the art will recognize that the terms "film" or "layer" used herein refer to a thickness of some material laid on or spread over a surface and that the surface may be a trench or a line. Throughout the specification and claims, the wafer and any associated layers thereon are referred to as substrates. In many instances though, the preferred substrate utilized may be selected from copper, silicon oxide, photoresist, hydrogenated carbon, TiN, SRO, Ru, and Si type substrates, such as polysilicon or crystalline silicon substrates. For example, a silicon nitride film may be deposited onto a Si layer. In subsequent processing, alternating silicon oxide and silicon nitride layers may be deposited on the silicon nitride layer forming a stack of multiple SiO₂/SiN layers used in 3D NAND gates. Furthermore, the substrate may be coated with patterned or unpatterned organic or inorganic films.

In addition to the disclosed Si-containing film forming compositions, a reactant may also be introduced into the reactor. The reactant may be an oxidizing agent, such as one of O₂, O₃, H₂O, H₂O₂; oxygen containing radicals, such as O· or OH·, NO, NO₂; carboxylic acids such as formic acid, acetic acid, propionic acid, radical species of NO, NO₂, or the carboxylic acids; para-formaldehyde; and mixtures thereof. Preferably, the oxidizing agent is selected from the group consisting of O₂, O₃, H₂O, H₂O₂, oxygen containing radicals thereof such as O· or OH·, and mixtures thereof. Preferably, when an ALD process is performed, the reactant is plasma treated oxygen, ozone, or combinations thereof. When an oxidizing agent is used, the resulting silicon containing film will also contain oxygen.

Alternatively, the reactant may be a nitrogen-containing reactant, such as one of N₂, NH₃, hydrazines (for example, N₂H₄, MeHNNH₂, MeHNNHMe), organic amines (for example, N(CH₃)H₂, N(C₂H₅)H₂, N(CH₃)₂H, N(C₂H₅)₂H, N(CH₃)₃, N(C₂H₅)₃, (SiMe₃)₂NH), pyrazoline, pyridine, diamine (such as ethylene diamine), radicals thereof, or mixtures thereof. When an N-containing source agent is used, the resulting silicon containing film will also contain nitrogen.

When a reducing agent is used, such as H₂, H radicals, but also other H-containing gases and precursors such as metal and metalloid hydrides, the resulting silicon containing film may be pure Si.

The reactant may be treated by plasma, in order to decompose the reactant into its radical form. N₂ may also be utilized when treated with plasma. For instance, the plasma may be generated with a power ranging from about 50W to about 2000W, preferably from about 100W to about 500W. The plasma may be generated or present within the reactor itself. Alternatively, the plasma may generally be at a location removed from the reactor, for instance, in a remotely located plasma system. One of skill in the art will recognize methods and apparatus suitable for such plasma treatment.

The Si-containing film forming compositions may also be used with a halosilane or polyhalodisilane, such as hexachlorodisilane, pentachlorodisilane, or tetrachlorodisilane, and one or more reactants to form Si, SiCN, or SiCOH films. PCT Publication Number WO2011/123792 discloses a SiN layer (not a Si or SiCOH layer).

When the desired silicon-containing film also contains another element, such as, for example and without limitation, Ti, Hf, Zr, Ta, Nb, V, Al, Sr, Y, Ba, Ca, As, B, P, Sb, Bi, Sn, Ge lanthanides (such as Er), or combinations thereof, another precursor may include a metal-containing precursor which is selected from, but not limited to:.
- Metal Halides (e.g., TiCl₄, TiI₄, TaCl₅, HfCl₄, ZrCl₄, AlCl₃, NbF₅, *etc.);*
- Alkyls (Al, Ge, Ga, In, Sb, Sn, Zn), such as trimethylaluminum, diethylzinc, triethylgalium;
- Hydrides (GeH4, alanes, *etc.);*
- Alkylamides (metals of group IV and V transition metals);
- Imido group (metals of group V and VI);
- Alkoxides (metals of group IV, V);
- Cyclopentadienyls (Ru, Co, Fe, Group IV transition metals, lanthanides, *etc.);*
- Carbonyls (ex: Ru, Co, Fe, Ni);
- Amidinates and guanidinates (ex : Co, Mn, Ni, Cu, Sc, *etc.);*
- Beta-diketonates (*e*.*g.,:* Sc, Cu, lanthanides);
- Beta-diketoimines (Cu, Ni, Co, etc.);
- Bis-trialkylsilylamides (Ni, Co, Fe, *etc.);*
- Oxo groups (RuO₄, WOCl₄, PO(OEt)₃, AsO(OEt)₃, *etc.);*
- Heteroleptic molecules having a mixed set of ligands selected from the above families.

The Si-containing film forming compositions and one or more reactants may be introduced into the reaction chamber simultaneously (e.g., CVD), sequentially (e.g., ALD), or in other combinations. For example, the Si-containing film forming composition may be introduced in one pulse and two additional metal sources may be introduced together in a separate pulse (e.g., modified ALD). Alternatively, the reaction chamber may already contain the reactant prior to introduction of the Si-containing film forming composition. The reactant may be passed through a plasma system localized or remotely from the reaction chamber, and decomposed to radicals. Alternatively, the Si-containing film forming composition may be introduced to the reaction chamber continuously while other metal sources are introduced by pulse (e.g., pulsed-CVD). In each example, a pulse may be followed by a purge or evacuation step to remove excess amounts of the component introduced. In each example, the pulse may last for a time period ranging from about 0.01s to about 20s, alternatively from about 0.3s to about 3s, alternatively from about 0.5s to about 2s. In another alternative, the Si-containing film forming composition and one or more reactants may be simultaneously sprayed from a shower head under which a susceptor holding several wafers is spun (e.g., spatial ALD).

In a non-limiting exemplary ALD type process, the vapor phase of the Si-containing film forming composition is introduced into the reaction chamber, where it is contacted with a suitable substrate and forms a silicon-containing layer on the substrate. Excess composition may then be removed from the reaction chamber by purging and/or evacuating the reaction chamber. An oxygen source is introduced into the reaction chamber where it reacts with the silicon-containing layer in a self-limiting manner. Any excess oxygen source is removed from the reaction chamber by purging and/or evacuating the reaction chamber. If the desired film is a silicon oxide film, this two-step process may provide the desired film thickness or may be repeated until a film having the necessary thickness has been obtained.

Alternatively, if the desired film is a silicon metal oxide film (i.e., SiMOₓ, wherein x may be 4 and M is Ti, Hf, Zr, Ta, Nb, V, Al, Sr, Y, Ba, Ca, As, B, P, Sb, Bi, Sn, Ge, lanthanides (such as Er), or combinations thereof), the two-step process above may be followed by introduction of a second vapor of a metal-containing precursor into the reaction chamber. The metal-containing precursor will be selected based on the nature of the silicon metal oxide film being deposited. After introduction into the reaction chamber, the metal-containing precursor is contacted with the silicon oxide layer on the substrate. Any excess metal-containing precursor is removed from the reaction chamber by purging and/or evacuating the reaction chamber. Once again, an oxygen source may be introduced into the reaction chamber to react with the metal-containing precursor. Excess oxygen source is removed from the reaction chamber by purging and/or evacuating the reaction chamber. If a desired film thickness has been achieved, the process may be terminated. However, if a thicker film is desired, the entire four-step process may be repeated. By alternating the provision of the Si-containing film forming compositions, metal-containing precursor, and oxygen source, a film of desired composition and thickness may be deposited.

Additionally, by varying the number of pulses, films having a desired stoichiometric M:Si ratio may be obtained. For example, a SiMO₂ film may be obtained by having one pulse of the mono-substituted TSA precursor and one pulses of the metal-containing precursor, with each pulse being followed by pulses of the oxygen source. However, one of ordinary skill in the art will recognize that the number of pulses required to obtain the desired film may not be identical to the stoichiometric ratio of the resulting film.

In a non-limiting exemplary PE-ALD type process, the vapor phase of the Si-containing film forming composition is introduced into the reaction chamber, where it is contacted with a suitable substrate, while a low reactivity oxygen source, such as O₂, is continuously flowing to the chamber. Excess composition may then be removed from the reaction chamber by purging and/or evacuating the reaction chamber. A plasma is then lit to activate the oxygen source to react with the absorbed mono-substituted TSA precursor in a self-limiting manner. The plasma is then switched off and the flow of the Si-containing film forming composition may proceed immediately after. This two-step process may provide the desired film thickness or may be repeated until a silicon oxide film having the necessary thickness has been obtained. The silicon oxide film may contain some C impurities, typically between 0.005% and 2%. The oxygen gas source and the substrate temperature may be selected by one of ordinary skill in the art so as to prevent reaction between the oxygen source and the mono-substituted TSA when the plasma is off. Dialkylamino-substituted TSA are particularly suitable for such a process, and are preferably (SiH₃)₂N-SiH₂-NEt₂, (SiH₃)₂N-SiH₂-NiPr₂ or (SiH₃)₂N-SiH₂-NHR, R being -tBu or -SiMe₃.

In another non-limiting exemplary PE-ALD type process, the vapor phase of the Si-containing film forming compositions is introduced into the reaction chamber, where it is contacted with a suitable substrate, while a low reactivity nitrogen source, such as N₂, is continuously flowing to the chamber. Excess composition may then be removed from the reaction chamber by purging and/or evacuating the reaction chamber. A plasma is then lit to activate the nitrogen source to react with the absorbed mono-substituted TSA precursor in a self-limiting manner. The plasma is then switched off and flow of the Si-containing film forming composition may proceed immediately after. This two-step process may provide the desired film thickness or may be repeated until a silicon nitride film having the necessary thickness has been obtained. The silicon nitride film may contain some C impurities, typically between 0.5% and 10%. The nitrogen gas source and the substrate temperature may be selected by one of ordinary skill in the art so as to prevent reaction between the nitrogen source and the mono-substituted TSA when the plasma is off. Amino-substituted TSA and mono-halo TSA are particularly suitable for such a process, and are preferably (SiH₃)₂N-SiH₂-Cl, (SiH₃)₂N-SiH₂-NEt₂, (SiH₃)₂N-SiH₂-NiPr₂, (SiH₃)₂N-SiH₂-NHR, R being -tBu or -SiMe₃, or (SiH₃)₂N-SiH₂-N(SiH₃)₂.

In a non-limiting exemplary LPCVD type process, the vapor phase of the Si-containing film forming compositions, preferably containing a mono-halo substituted TSA precursor, is introduced into the reaction chamber holding the substrates and kept at a pressure typically between 0.1 and 10 torr, and more preferably between 0.3 and 3 torr, and at a temperature between 250°C and 800°C, preferably between 350°C and 600°C, where it is mixed with a reactant, typically NH₃. A thin conformal SiN film may thus be deposited on the substrate(s). One of ordinary skill in the art will recognize that the Si/N ratio in the film may be tuned by adjusting the mono-substituted TSA precursor and N-source flow rates.

In another alternative, dense SiN films may be deposited using an ALD method with hexachlorodisilane (HCDS), pentachlorodisilane (PCDS), monochlorodisilane (MCDS), dichlorodisilane (DCDS) or monochlorosilane (MCS), the disclosed Si-containing film forming compositions, and an ammonia reactant. The reaction chamber may be controlled at 5Torr, 550°C, with a 55 sccm continuous flow of Ar. An approximately 10second long pulse of the disclosed Si-containing film forming composition at a flow rate of approximately 1 sccm is introduced into the reaction chamber. The composition is purged from the reaction chamber with an approximately 55 sccm flow of Ar for approximately 30 seconds. An approximately 10 second pulse of HCDS at a flow rate of approximately 1 sccm is introduced into the reaction chamber. The HCDS is purged from the reaction chamber with an approximately 55 sccm flow of Ar for approximately 30 seconds. An approximately 10 second long pulse of NH₃ at a flow rate of approximately 50 sccm is introduced into the reaction chamber. The NH₃ is purged from the reaction chamber with an approximately 55 sccm flow of Ar for approximately 10 seconds. These 6 steps are repeated until the deposited layer achieves a suitable thickness. One of ordinary skill in the art will recognize that the introductory pulses may be simultaneous when using a spatial ALD device. As described in PCT Pub No WO2011/123792, the order of the introduction of the precursors may be varied and the deposition may be performed with or without the NH₃ reactant in order to tune the amounts of carbon and nitrogen in the SiCN film. One of ordinary skill in the art would further recognize that the flow rates and pulse times may vary amongst different deposition chambers and would be able to determine the necessary parameter for each device.

In a non-limiting exemplary process, the vapor phase of the disclosed Si-containing film forming compositions, preferably containing mono-halo substituted TSA, is introduced into the reaction chamber holding a substrate having a porous low-k film. A pore sealing film may be deposited in the conditions described in US 2015/0004806 (i.e., by introducing the disclosed silicon-containing film forming composition, an oxidant (such as ozone, hydrogen peroxide, oxygen, water, methanol, ethanol, isopropanol, nitric oxide, nitrous dioxide, nitrous oxide, carbon monoxide, or carbon dioxide), and a halogen free catalyst compound (such as nitric acid, phosphoric acid, sulfuric acid, ethylenediaminetetraacetic acid, picric acid, or acetic acid) to a reaction chamber and exposing the substrate to the process gases under conditions such that a condensed flowable film forms on the substrate).

In yet another alternative, a silicon-containing film may be deposited by the flowable PECVD method disclosed in U.S. Patent Application Publication No. 2014/0051264 using the disclosed compositions and a radical nitrogen- or oxygen-containing reactant. The radical nitrogen- or oxygen-containing reactant, such as NH₃ or H₂O respectively, is generated in a remote plasma system. The radical reactant and the vapor phase of the disclosed precursors are introduced into the reaction chamber where they react and deposit the initially flowable film on the substrate. Applicants believe that the nitrogen atoms of the (SiH₃)₂N-(SiH₂-X) structure helps to further improve the flowability of the deposited film, resulting in films having less voids, especially when X is an amino group, and more specifically when X is a disilylamino group like -N(SiH₃)₂.

The silicon-containing films resulting from the processes discussed above may include SiO₂, nitrogen doped silicon oxide, SiN, SiON, SiCN, SiCOH, or MSiN_{y}Oₓ, wherein M is an element such as Ti, Hf, Zr, Ta, Nb, V, Al, Sr, Y, Ba, Ca, As, B, P, Sb, Bi, Sn, Ge, and x, y may be from 0-4 and y+x=4, depending of course on the oxidation state of M. One of ordinary skill in the art will recognize that by judicial selection of the appropriate mono-substituted TSA precursor and reactants, the desired film composition may be obtained.

Upon obtaining a desired film thickness, the film may be subject to further processing, such as thermal annealing, furnace-annealing, rapid thermal annealing, UV or e-beam curing, and/or plasma gas exposure. Those skilled in the art recognize the systems and methods utilized to perform these additional processing steps. For example, the silicon-containing film may be exposed to a temperature ranging from approximately 200°C and approximately 1000°C for a time ranging from approximately 0.1 second to approximately 7200 seconds under an inert atmosphere, a H-containing atmosphere, a N-containing atmosphere, an O-containing atmosphere, or combinations thereof. Most preferably, the temperature is 600°C for less than 3600 seconds under a reactive H-containing atmosphere. The resulting film may contain fewer impurities and therefore may have improved performance characteristics. The annealing step may be performed in the same reaction chamber in which the deposition process is performed. When the deposition process is a FCVD, the curing step is preferably an oxygen curing step, carried out at a temperature lower than 600°C. The oxygen containing atmosphere may contain H₂O or O₃. Alternatively, the substrate may be removed from the reaction chamber, with the annealing/flash annealing process being performed in a separate apparatus.

### Examples

The following non-limiting examples are provided to further illustrate embodiments of the invention. However, the examples are not intended to be all inclusive and are not intended to limit the scope of the inventions described herein.

The examples described herein are TSA based precursors, i.e., mono-substituted TSA.

### Example 1: Synthesis of (SiH₃)₂N-SiH₂-NiPr₂ and of (SiH₃)₂N-SiH₂-NEt₂

300g of diisopropylamine (3.0mol) was charged to a 1-liter filter flask equipped with an overhead mechanical stirrer, a nitrogen bubbler, a chiller and a hydride scrubber as a reactor. 60g (0.4mol) of chlorotrisilylamine was charged to a dropping funnel. The dropping funnel was affixed to the reactor. A nitrogen sweep was added to the dropping funnel to prevent salt formation in the tip of the funnel. The chiller was set to 18°C and the chlorotrisilylamine was added via dropping funnel over a 1.5hr period. The reactor temperature was set at 22-23°C during the addition. The reactor was allowed to stir for 0.5hr after the addition was complete.

The amine hydrochloride salt was then filtered. The filter cake was rinsed with two 50ml aliquots of diisopropylamine. The majority of the diisopropylamine was distilled off leaving 72g of a crude product. The crude product was combined with other crude products from several smaller scale preparations of (SiH₃)₂N-SiH₂-NiPr₂ done in a similar fashion. (SiH₃)₂N-SiH₂-NiPr₂ was then distilled at 86°C under a vacuum of -28 inches of mercury and 79g of > 99% pure product was collected. The overall yield was 56%. Table 1 shows vapor pressure data of (SiH₃)₂N-SiH₂-NiPr₂ estimated from the distillation and TSU data.

**Table 1. Vapor pressure data of (SiH₃)₂N-SiH₂-NiPr₂**

| **Temperature (°C)** | **Pressure (torr)** |
|---|---|
| 86 | 38 |
| 100 | 72 |
| 150 | 140 |

The synthesis of (SiH₃)₂N-SiH₂-NEt₂ proceeds similarly with the same molar ratio, but replaces diisopropylamine with diethylamine.

### Example 2: Synthesis of (SiH₃)₂N-SiH₂-NHiPr

300g of isopropylamine (3.0mol) was charged to a 1-liter filter flask equipped with an overhead mechanical stirrer, a nitrogen bubbler, a chiller and a hydride scrubber as a reactor. 60g (0.4mol) of chlorotrisilylamine was charged to a dropping funnel. The dropping funnel was affixed to the reactor. A nitrogen sweep was added to the dropping funnel to prevent salt formation in the tip of the funnel. The chiller was set to 18°C and the chlorotrisilylamine was added via dropping funnel over a 1.5hr period. The reactor temperature was set at 22-23°C during the addition. The reactor was allowed to stir for 0.5hr after the addition was complete.
The amine hydrochloride salt was then filtered. The filter cake was rinsed with two 50mL aliquots of isopropylamine. The majority of the isopropylamine was distilled off leaving 72g of a crude product. The crude product was combined with other crude products from several smaller scale preparations of (SiH₃)₂N-SiH₂-NHiPr done in a similar fashion. (SiH₃)₂N-SiH₂-NHiPr was then distilled at 86°C under a vacuum of - 28 inches of mercury and 79g of > 99% pure product was collected.

### Example 3 (not falling under the scope of the invention as claimed in the appended claims): Synthesis of (SiH₃)₂N-SiH₂-Br and of (SiH₃)₂N-SiH₂-N(SiH₃)₂

(SiH₃)₂N-SiH₂-Br and (SiH₃)₂N-SiH₂-N(SiH₃)₂ may be obtained by reacting SnBr₄ with TSA: SnBr₄ + H₃SiN(SiH₃)₂ = BrH₂SiN(SiH₃)₂ + (SiH₃)₂N-SiH₂-N(SiH₃)₂+ SnBr₂ + HBr. A side product of the above reaction, HBr, may then be removed by a reaction with the starting material TSA, *i.e.,* N(SiH₃)₃ + 4HBr = NH₄Br + 3BrSiH₃. The synthesis process is as follows.

A round bottom flask with a PTFE-coated magnetic stir egg was charged with stoichiometric excess of TSA. If necessary, a solvent (*e.g.,* dodecane) and an HBr scavenger (*e.g.,* tributylamine) may be added to the flask prior to adding TSA. The flask was fitted with a cold finger condenser or a distillation head. A liquid addition funnel was attached to the flask and charged with a solution of SnBr₄ in a solvent (such as, anisole or dodecane). The flask may then be cooled down and the SnBr₄ solution was added dropwise to the flask. The headspace of the flask may be kept under atmospheric pressure of nitrogen or at a reduced pressure in order to remove HBr as it forms.

After the addition was finished, the volatile products may be collected by pulling vacuum through trap(s). The collected volatile products may then be analyzed by GCMS. It was found that (SiH₃)₂N(SiH₂Br) and (SiH₃)₂N(SiH₂N(SiH₃)₂) were formed upon treating TSA with SnBr₄. The following byproducts were also identified: silane, bromosilane, dibromotrisilylamine. The solvents and unreacted SnBr₄ (in some cases) were also found.

The resulting (SiH₃)₂N-SiH₂-N(SiH₃)₂ was liquid at room temperature (∼22°C), with a melting point of approximately -106°C and a boiling point of approximately 131°C. The vapor pressure was calculated to be ∼8 hPa at 27°C.

### Comparative Example 1

In WO2015/190749 to DNF Co., Ltd., Example 1 discloses the synthesis of dimethylaminodimethylsilyl bisdimethylsilyl amine [(Me₂SiH)₂NSiMe₂(NMe₂)] by reacting chlorodimethylsilane [Me₂HSiCl] in n-pentane with NH₃ to form tetraemethyldisilazane [(Me₂SiH)₂NH], The tetramethyldisilazane is then reacted with n-BuLi in a n-hexane solvent to form (Me₂SiH)₂N-Li. Chlorodimethyl dimethylaminosilane [ClSiMe₂(NMe₂)] is added to the mixture to then form the (Me₂SiH)₂NSiMe₂(NMe₂) product.

One of ordinary skill in the art would recognize that the synthesis method described in Example 1 would not be suitable to produce the molecules disclosed herein containing the (SiH₃)₂N- moiety. DNF's proposed synthesis method would require the synthesis and isolation of the amine (SiH₃)₂NH followed by its treatment with the strong base, tBuLi, in liquid phase. It is well known in the literature that the (SiH₃)₂NH amine may be prepared and handled in its gas phase, but is not stable in liquid phase and decomposes even at 0°C. See, e.g., Silicon-nitrogen compounds. VI. Preparation and properties of disilazane"; Aylett, Bernard J.; Hakim, M. J.; Journal of the Chemical Society [Section] A: Inorganic, Physical, Theoretical, 1969, 4, 639-642. More particularly, (SiH₃)₂NH rapidly disproportionates in the presence of a weak base, such as liquid NH₃. *Id.* Therefore, one of ordinary skill in the art would recognize that a much stronger base, such as ^{t}BuLi, would cause even faster disproportionation. As a result, one of ordinary skill in the art would not expect success in the synthesis of the required (SiH₃)₂NLi intermediate salt, which is necessary for the next step in the synthesis.

The method described in Example 1 of WO2015/190749 for the preparation of amines with the formula (SiHR₂)₂NH implies the reaction of chlorosilanes SiHR₂Cl with NH₃ in stoichiometric amount. In the case of SiH₃X (X = CI, Br, I), Stock *et al.* reported the impossibility of isolating gaseous (SiH₃)₂NH by this method because the reaction did not stop at the bis-substituted product and formed the tris-substituted amine (SiH₃)₃N. See, *e.g.,* Stock, A. and Somieski, C.; Chem. Ber., 1921, 54B, 740. All of the aforementioned arguments, together with the total absence of any reference describing the formation of a lithium silylamide with more than one hydride in each silicon atom, prove that it is not feasible to prepare (SiH₃)₂N- or (SiH₂R)₂N- containing aminosilanes by the synthetic route described in WO2015/190749.

In contrast, as shown in Examples 1-3, Applicants have successfully synthesized the disclosed (SiH₃)₂N-containing compounds by using (SiH₃)₂N-SiH₂Cl as a starting material.

### Example 4

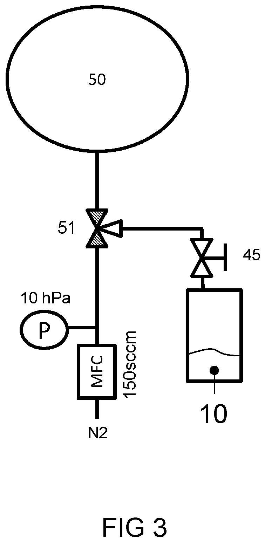

The following PEALD testing was performed using a Picosun R200 PEALD 8" deposition tool with a 4" wafer. The vapor of the mono-substituted TSA precursor was delivered to the Picosun tool as shown in **FIG 3****.**

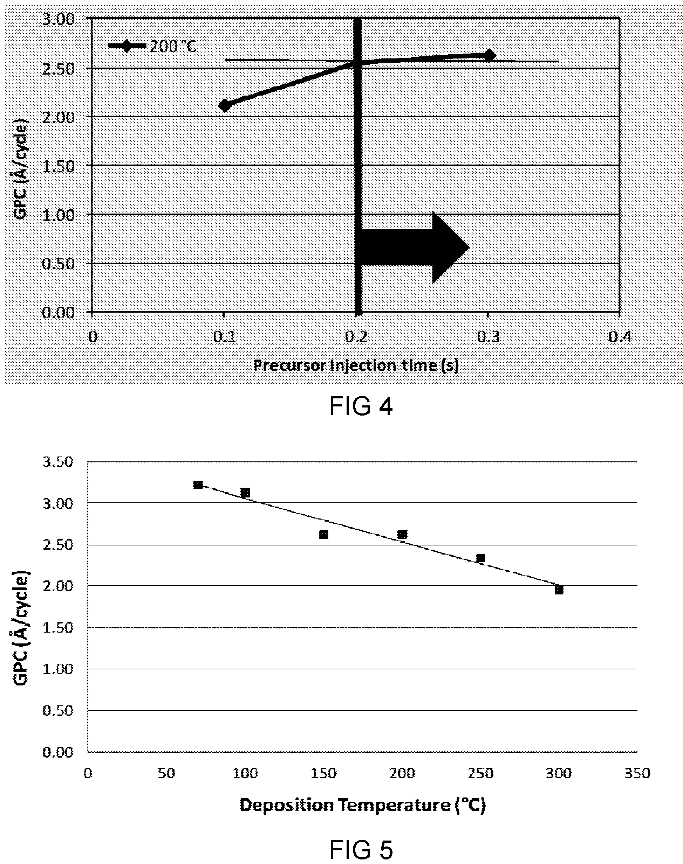

ALD tests were performed using (SiH₃)₂N-SiH₂-NiPr₂ as the silicon-containing film forming composition **10,** which was placed in an ampoule heated to 70°C and O₂ plasma as oxidizing reactant. Typical ALD conditions were used with the reactor **50** pressure fixed at ∼9 hPa (1 hPa=100 Pa=1mbar). Two 0.1-second pulses of the precursor vapor were introduced into the deposition chamber via overpressure in the ampoule using the 3-way pneumatic valve **51.** The 0.1-second pulses were separated by a 0.5 second pause. A 4-second N₂ purge removed any excess precursor. A 16-second plasma O₂ pulse was followed by a 3-second N₂ purge. The process was repeated until a minimum thickness of 300 Angstrom was obtained. Depositions were performed with the substrate heated to 70°C, 150°C, and 300°C. Real self limited ALD growth behavior was validated as shown in **FIG 4** by increasing the number of precursor pulses within a given cycle.

ALD tests were also performed using the prior art SiH₂(NEt₂)₂ precursor as the Si-containing film forming composition **10,** which was placed in an ampoule heated to 60°C and O₂ plasma as oxidizing reactant. Applicants believe that SiH₂(NEt₂)₂ is currently used to deposit SiO₂ in several commercial processes. Typical ALD conditions were used with the reactor pressure fixed at ∼9 hPa (1 hPa=100 Pa=1mbar). Two 0.1-second pulses of the precursor vapor were introduced into the deposition chamber via overpressure in the ampoule using the 3-way pneumatic valve. The 0.1-second pulses were separated by a 0.5 second pause. A 4-second N₂ purge removed any excess precursor. A 16-second plasma O₂ pulse was followed by a 3-second N₂ purge. The process was repeated until a minimum thickness of 300 Ang was reached. Depositions were performed at 70°C, 150°C, 200°C, and 300°C. As shown in **FIG 5****,** the growth per cycle decreased with increasing temperature.

**Table 2 summarizes the results:**

| | SiH₂(NEt₂)₂ | (SiH₃)₂N-SiH₂-NiPr₂ |
|---|---|---|
| Growth rate 70°C¹ | 1.42 Ang/cycle | 3.10 Ang/cycle |
| Growth rate 300°C¹ | 0.98 Ang/cycle | 2.05 Ang/cycle |
| Wet Etch Rate 70°C² | 9.4 Ang/sec | 8.8 Ang/sec |
| Wet Etch Rate 150°C² | 7.2 Ang/sec | 6.7 Ang/sec |
| Wet Etch Rate 300°C² | 6.6 Ang/sec | 6.7 Ang/sec |
| Refractive Index 70°C³ | 1.432 | 1.460 |
| Atomic % Carbon 70°C⁴ | 0.05% | TBD |
| Atomic % Carbon 150°C⁴ | 0.045% | 0,015-0,03% |
| Atomic % Hydrogen 150°C⁴ | ^{∼}10% | ^{∼}10% |
| Atomic % Nitrogen 150°C⁴ | 0.015% | 0,1% |
| Within Wafer Non Uniformity⁵ | 2.84% | 2.90% |

| | | |
|---|---|---|
| ¹Growth rate for films deposited at the stated temperatures ² Wet Etch Rate using 0.1% v/v HF (determined by ellipsometry) of films deposited at the stated temperatures ³ Refractive index for film deposited at 70°C ⁴ Atomic percentage in a film deposited at the stated temperature as determined by Secondary Ion Mass Spectrometry (SIMS). Hydrogen content is subject to uncertainty when measured by SIMS, as one skilled in the art would recognize. ⁵ Within Wafer Non Uniformity of a film deposited at 200°C as determined by ellipsometer over a 6 inch silicon wafer. This parameter was not optimized and better uniformity would be expected from an industrial tool. | | |

As can be seen, the growth rate for films produced by (SiH₃)₂N-SiH₂-NiPr₂ is much better than those of SiH₂(NEt₂)₂ at both 70°C and 300°C. At 70°C, (SiH₃)₂N-SiH₂-NiPr₂ has a much better wet etch rate and refractive index than SiH₂(NEt₂)_{2.,} which both indicate formation of a much better, denser oxide film.

### Example 5

ALD tests to deposit N-doped silicon oxide were performed using the (SiH₃)₂N-SiH₂-NiPr₂, which was placed in an ampoule heated to 70°C, O₂ plasma as oxidizing reactant and NH₃ plasma as an additional reactant. Typical ALD conditions were used with the reactor pressure fixed at ∼9 hPa. Two 0.1-second pulses of the precursor vapor were introduced into the deposition chamber via overpressure in the ampoule using the 3-way pneumatic valve. The 0.1-second pulses were separated by a 0.5 second pause. A 4-second N₂ purge removed any excess precursor. A 16-second plasma O₂ pulse was followed by a 3-second N₂ purge. Two 0.1-second pulses of the precursor vapor were introduced into the deposition chamber via overpressure in the ampoule using the 3-way pneumatic valve. The 0.1-second pulses were separated by a 0.5 second pause. A 4-second N₂ purge removed any excess precursor. An 11-second plasma NH₃ pulse was followed by a 3-second purge. The entire process (precursor - plasma O₂ - precursor - plasma NH₃) was repeated until the thickness reached at least 300 Ang. Depositions were performed at 150°C.

The resulting SiO₂ film had a wet etch rate of 3.2 Ang/sec using 0.1% v/v HF (determined by ellipsometry) and N concentration of ∼1%. Such a low etch rate is found to be beneficial for spacer-based double patterning to enable a low edge roughness in the transfer layer when the ALD-deposited silicon oxide film is used as a mask. The person of ordinary skill in the art would recognize that the Oxygen to Nitrogen content in the obtained film can be tuned by adjusting the number, sequence or/and duration of the O containing reactant and N containing reactant pulses. Applicant believes that a N concentration of approximately 0.5 atomic % to approximately 5 atomic % in an SiO₂ film is beneficial for the spacer-defined patterning applications.

### Example 6 (not falling under the scope of the invention as claimed in the appended claims):

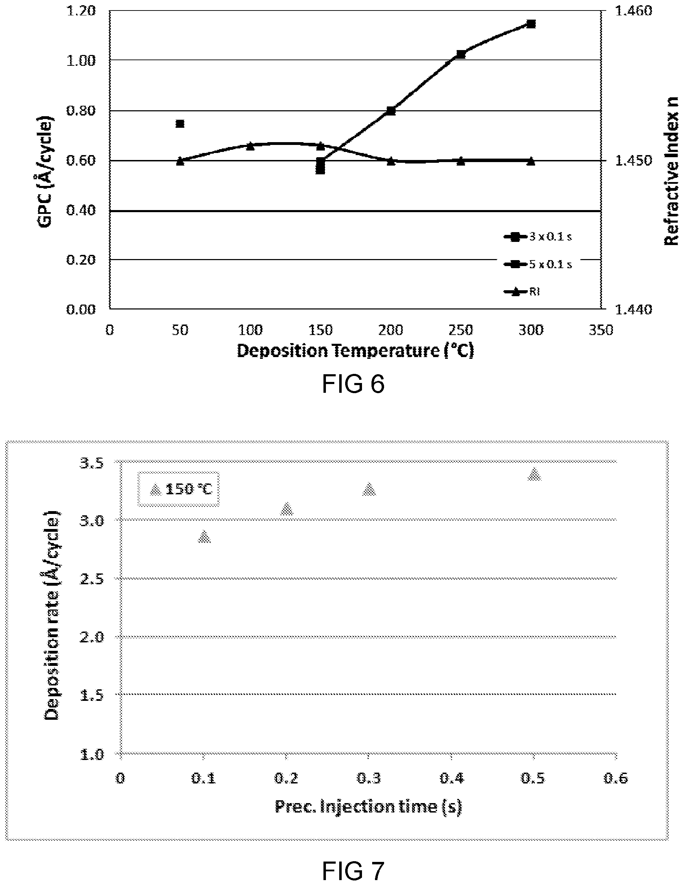

ALD tests were performed using the (SiH₃)₂N-SiH₂-N(SiH₃)₂, which was placed in an ampoule heated to 26°C and O₂ plasma as oxidizing reactant. Typical ALD conditions were used with the reactor pressure fixed at ∼9 hPa. Three 0.1-second pulses of the precursor vapor were introduced into the deposition chamber via overpressure in the ampoule using the 3-way pneumatic valve. The 0.1-second pulses were separated by a 0.5 second pause. A 4-second N₂ purge removed any excess precursor. A 16-second plasma O₂ pulse was followed by a 3-second N₂ purge. The entire process (precursor - plasma O2 -) was repeated until the thickness reached at least 300 Ang. As shown in **FIG 6****,** the growth per cycle increased with increasing deposition temperatures from 150°C to 300°C. **FIG 6** also shows comparative growth per cycle results of five 0.1-second pulses versus three 0.1-second pulses. Both were approximately 0.6 A/cycle, indicating true ALD saturation because the larger amounts of precursor introduced via 5 pulses do not result in a higher growth rate than the film produced by 3 pulses.

The growth rate was approximately 0.58 Ang/cycle at 150°C and resulted in a film having a refractive index of 1.45. For comparison, attempts to grow a SiO₂ film by ALD using pure TSA in similar conditions have not yielded any films, thus proving the benefit of the chemical functionalization to enhance the reactivity with the surface hydroxyl groups.

### Example 7

ALD tests were performed using (SiH₃)₂N-SiH₂-NEt₂ as the silicon-containing film forming composition **10,** which was placed in an ampoule heated to 70°C and O₂ plasma as oxidizing reactant. Typical ALD conditions were used with the reactor **50** pressure fixed at ∼9 hPa (1 hPa=100 Pa=1mbar). Two 0.1-second pulses of the precursor vapor were introduced into the deposition chamber via overpressure in the ampoule using the 3-way pneumatic valve **51.** The pulses were separated by a 0.5 second pause. A 4-second N₂ purge removed any excess precursor. A 16-second plasma O₂ pulse was followed by a 3-second N₂ purge. The process was repeated until a minimum thickness of 300 Angstrom was obtained. Depositions were performed with the substrate heated to 150°C. A self limited ALD growth behavior was found as shown in **FIG 7** by increasing the number of precursor pulses to reach a cumulative opening time higher than 0.4 second per cycle.

As in Example 4, the approximately 3.0 Å/cycle growth rate for films produced by (SiH₃)₂N-SiH₂-NEt₂ at 150°C is much better than the 1.42 Å/cycle and 0.98 Å/cycle produced by SiH₂(NEt₂)₂ at 70°C and 300°C, respectively.

### Example 8 (not falling under the scope of the invention as claimed in the appended claims):

ALD tests were performed using (SiH₃)₂N-SiH₂-Cl as the silicon-containing film forming composition **10,** which was placed in an ampoule heated to 30°C and O₂ plasma as oxidizing reactant. (SiH₃)₂N-SiH₂-Cl gas a molecular weight of 141.78, is liquid at room temperature and standard pressure, and has a boiling point at standard pressure between approximately 83°C and approximately 85°C.

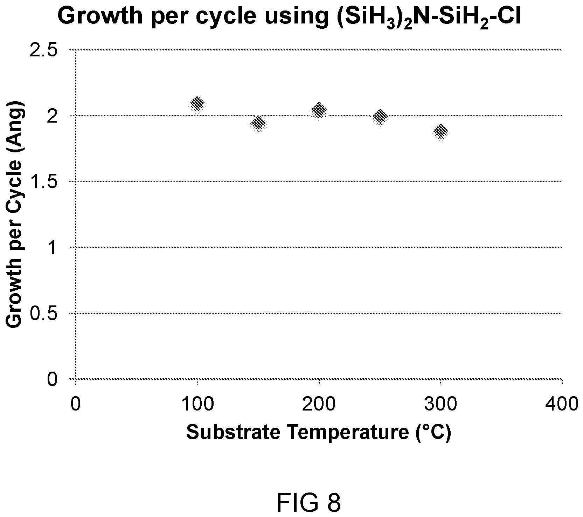

Typical ALD conditions were used with the reactor **50** pressure fixed at ∼9 hPa (1 hPa=100 Pa=1mbar). Two 0.1-second pulses of the precursor vapor were introduced into the deposition chamber via overpressure in the ampoule using the 3-way pneumatic valve **51.** The 0.1-second pulses were separated by a 0.5 second pause. A 4-second N₂ purge removed any excess precursor. A 16-second plasma O₂ pulse was followed by a 3-second N₂ purge. The process was repeated until a minimum thickness of 300 Angstrom was obtained. Depositions were performed with the substrate heated to 100°C, 150°C, 200°C, 250°C, and 300°C. As shown in **FIG 8****,** the growth per cycle remained steady (i.e., approximately 2 Å/cycle) with increasing deposition temperatures from 100°C to 300°C.

The resulting silicon oxide films were deposited at a high deposition rate (approximately 2Å/cycle) at multiple temperatures. These results are beneficial when temperature uniformity is difficult to maintain across the substrate (*i.e.,* for large substrates) or from one substrate to another due to temperature gradients in the reactor.

The average thickness of the film was also uniform across the wafer.

**Table 3 summarizes the film uniformity obtained. These results demonstrate extremely good film uniformity.**

| Experiment Number (Process Conditions) | Deposition Temp. (°C) | Average Thickness (Å) | Non Uniformity¹ (%) | σ² | 3 σ/Average (%) |
|---|---|---|---|---|---|
| 1272 (1 x 0.1 s) | 100 | 321 | 1.04 | 1.66 | 1.56 |
| 1256 (2 x. 0.1 s) | 100 | 329 | 1.07 | 1.59 | 1.45 |
| 1271 (3 x 0.1 s) | 100 | 323 | 0.93 | 1.34 | 1.24 |
| 1252 (1 x 0.1 s) | 150 | 590 | 1.30 | 4.45 | 2.26 |
| 1253 (2 x 0.1 s) | 150 | 585 | 1.96 | 6.61 | 3.39 |
| 1267 (1 x 0.1 s) | 200 | 319 | 0.66 | 1.09 | 1.03 |
| 1273 (2 x 0.1 s) | 200 | 325 | 1.15 | 1.94 | 1.79 |
| 1268 (3 x 0.1 s) | 200 | 324 | 1.15 | 2.01 | 1.87 |
| 1263 (1 x 0.1 s) | 250 | 362 | 0.74 | 1.37 | 1.13 |
| 1265 (2 x 0.1 s) | 250 | 317 | 0.88 | 1.27 | 1.20 |

| | | | | | |
|---|---|---|---|---|---|
| ¹ % non-uniformity = [(maximum thickness - minimum thickness)/(2x average)] x 100 ² σ = standard deviation | | | | | |

### Example 9 (not falling under the scope of the invention as claimed in the appended claims):

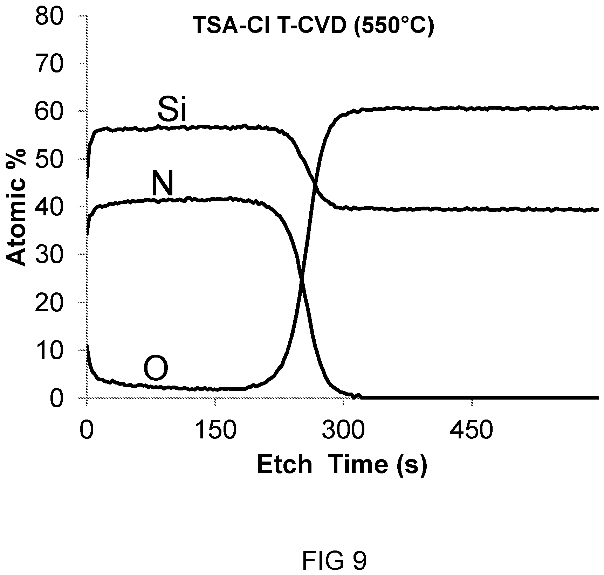

Thermal, low pressure CVD tests were performed using (SiH₃)₂N-SiH₂-Cl and NH₃ at 1 torr, 550°C, and a precursor to NH₃ ratio of 1:20. **FIG 9** is a X-ray Photoelectron Spectroscopy (XPS) graph showing the resulting film composition. Cl was below the detection limit of the analyser (< ∼ 1 atomic %). The deposition rate was 10 Å/min and the Refractive Index (RI) of the obtained film was 2.1. For comparison, films obtained in the same conditions with TSA had a RI of 2.2 (silicon rich) and a similar deposition rate. The resulting film had a very low etch rate (<20 Å/minute), which is beneficial in semiconductor integration schemes.

### Example 10 (not falling under the scope of the invention as claimed in the appended claims):

PE-ALD tests were performed at 250°C on a different ALD tool than the ALD tests performed in Examples 4-8 (i.e., a CN1 Atomic Premium vapor deposition apparatus) using a 150 mm wafer. (SiH₃)₂N-SiH₂-Cl (TSA-Cl) and plasma N₂ at 25 W and 100 W were used to deposit SiN films.

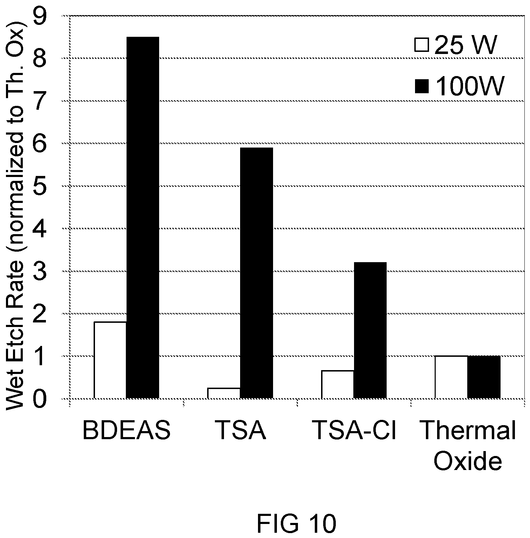

As shown in **FIG 10****,** the resulting films exhibited very low wet etch rate as compared to BDEAS (bis(diethylamino)silane), TSA, and the reference Thermal Oxide (Th-ox). The etch rates are described relative to a standard wet etch of thermally grown silicon dioxide (Thermal Oxide or Th-ox).

The SiN films produced by TSA and TSA-CI using 25 W had etch rates that were lower than the reference material Th-Ox. The lower etch rates mean that less material thickness is removed from the SiN films produced by TSA and TSA-CI than Th-Ox (under the same conditions and parameters). At 100 W, the etch rates of the SiN films produced by TSA-CI produce the closest results to the Th-Ox.

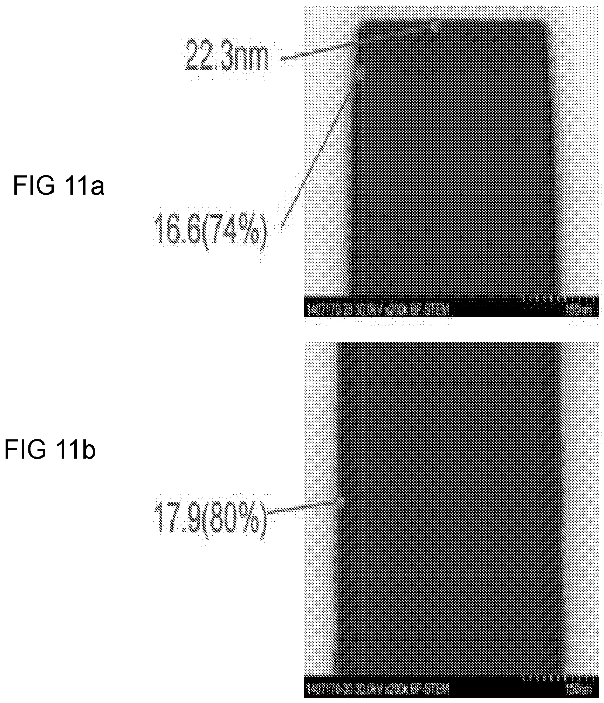

**FIGS 11** **a and b** are Scanning Electron Microscope (SEM) images showing good step coverage and conformality of the SiN films deposited on a structure located between two vias having a 5:1 aspect ratio.

### Example 11

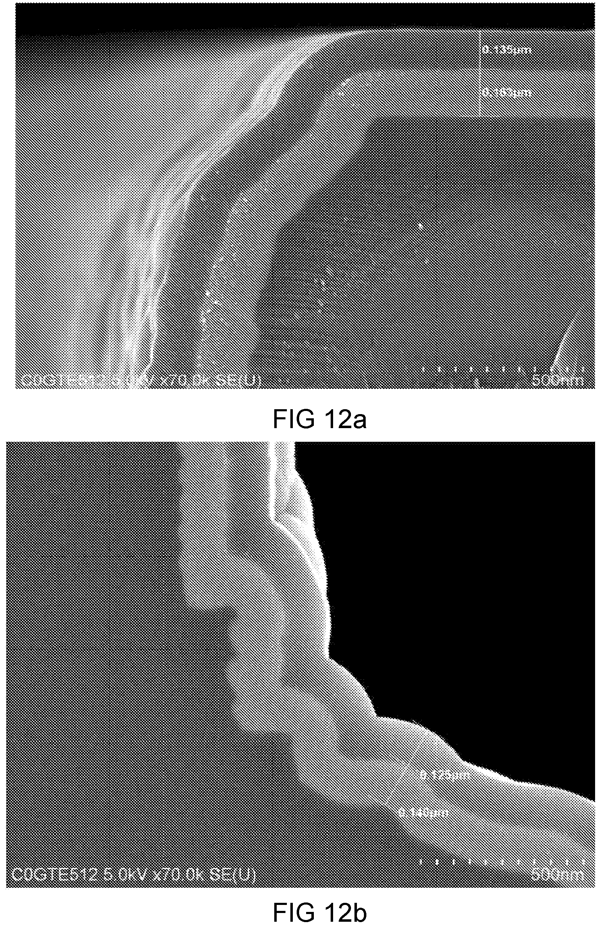

**FIGS 12** **a and b** are SEM images showing the silicon oxide film obtained by spatial ALD with TSA-NiPr₂ / O₂ plasma at 60 cycles per minutes, 100°C, indicating a perfect step coverage in a 22:1 high aspect ratio structure. A clear underlying Ta₂O₅ layer was added for contrast enhancement. The pictures are taken at the top **(****FIG 12a****)** and bottom **(****FIG 12b****)** of the trench structure.

### Example 12

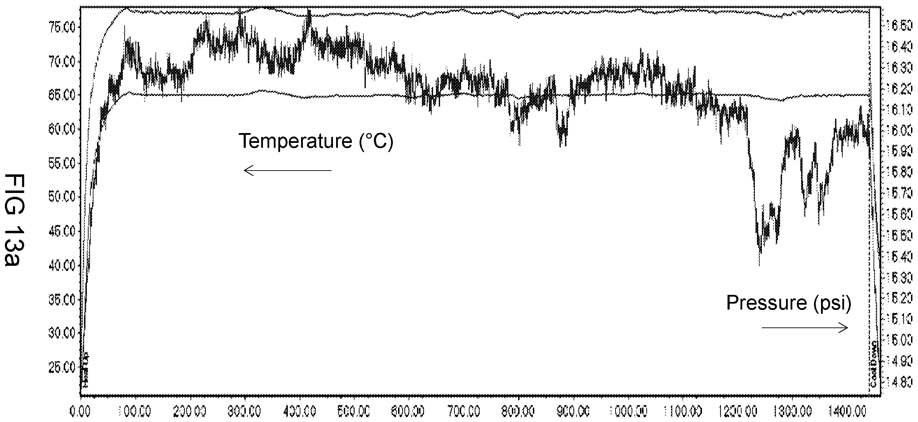

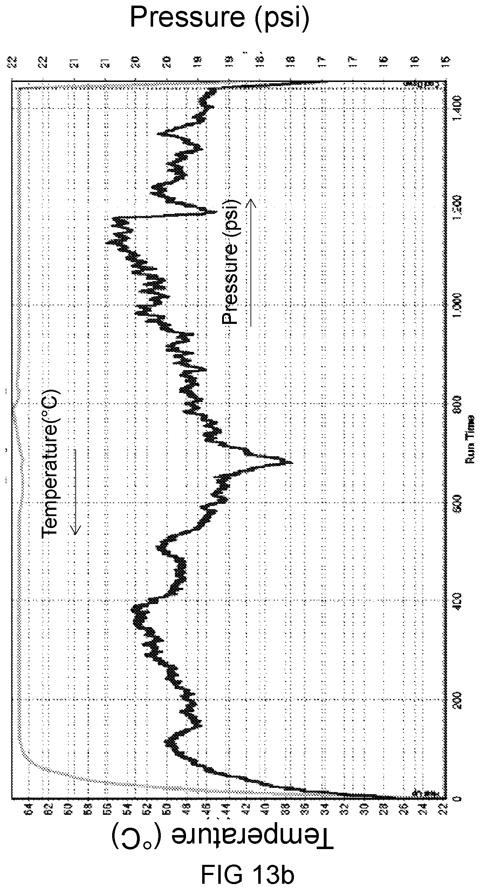

**FIGS 13** **a and b** are graphs showing the thermal stability of TSA-NiPr₂ and TSA-NEt₂ [(H₃Si)₂-N-SiH₂-NiPr₂ and (H₃Si)₂-N-SiH₂-NEt₂], respectively, by thermal screening unit. In such a measurement, the pressure of a sealed sample is measured continuously during 24 hours at a set temperature (here 65°C). A lack of significant pressure change indicates product stability. The observed P oscillation are insignificant here and associated with minute T variations.

While embodiments of this invention have been shown and described, modifications thereof may be made by one skilled in the art without departing from the scope of the invention as claimed in the appended claims. The embodiments described herein are exemplary only and not limiting. Many variations and modifications of the composition and method are possible and within the scope of the invention. invention as claimed in the appended claims. Accordingly the scope of protection is not limited to the embodiments described herein, but is only limited by the claims which follow, the scope of which shall include all equivalents of the subject matter of the claims.

## Claims

1. A silicon- and nitrogen-containing film formation process, the process comprising the steps of:
Depositing a silicon- and nitrogen-containing film on a substrate by introducing a vapor of a mono-substituted TSA precursor and a nitrogen-containing reactant into a reactor containing the substrate, the mono-substituted TSA precursor having a formula (SiH₃)₂N-SiH₂-X, **characterized in that** X is an amino group [-NR₂] and each R is independently selected from the group consisting of H; a C₁-C₆ hydrocarbyl group.

2. The silicon- and nitrogen-containing film formation process of claim 1, wherein X is NiPr₂.

3. The silicon- and nitrogen-containing film formation process of claim 1, wherein X is NEt₂.

4. The silicon- and nitrogen-containing film formation process of any one of claims 1 to 3, wherein the nitrogen-containing reactant is selected from the group consisting of ammonia, N₂, N atoms, N radicals, N ions, saturated or unsaturated hydrazine, amines, diamines, ethanolamine, and combinations thereof.

5. The silicon- and nitrogen-containing film formation process of claim 4, wherein the nitrogen-containing reactant is NH₃.

6. The silicon- and nitrogen-containing film formation process of claim 5, wherein the mono-substituted TSA precursor and the nitrogen-containing reactant are introduced into the reactor simultaneously.

7. The silicon- and nitrogen-containing film formation process of claim 4, wherein the nitrogen-containing reactant is plasma N₂.

8. The silicon- and nitrogen-containing film formation process of claim 7, wherein the mono-substituted TSA precursor and the nitrogen-containing reactant are introduced into the reactor sequentially.

## Patentansprüche

1. Verfahren zur Bildung eines Silicium- und Stickstoff- enthaltenden Films, wobei das Verfahren die Schritte umfasst des:
Abscheidens eines Silicium- und Stickstoff-enthaltenden Films auf einem Substrat durch Einführen eines Dampfes eines monosubstituierten TSA-Vorläufers und eines Stickstoff-enthaltenden Reaktanten in einen Reaktor, der das Substrat enthält, wobei der monosubstituierte TSA-Vorläufer eine Formel (SiH₃)₂N-SiH₂-X aufweist, **dadurch gekennzeichnet, dass** X eine Aminogruppe [-NR₂] ist und jedes R unabhängig ausgewählt ist aus der Gruppe bestehend aus H; einer C₁-C₆-Hydrocarbylgruppe.

2. Verfahren zur Bildung eines Silicium- und Stickstoff-enthaltenden Films nach Anspruch 1, wobei X NiPr₂ ist.

3. Verfahren zur Bildung eines Silicium- und Stickstoff-enthaltenden Films nach Anspruch 1, wobei X NEt₂ ist.

4. Verfahren zur Bildung eines Silicium- und Stickstoff-enthaltenden Films nach einem der Ansprüche 1 bis 3, wobei der Stickstoff-enthaltende Reaktant ausgewählt ist aus der Gruppe bestehend aus Ammoniak, N₂, N-Atomen, N-Radikalen, N-Ionen, gesättigtem oder ungesättigtem Hydrazin, Aminen, Diaminen, Ethanolaminen und Kombinationen davon.

5. Verfahren zur Bildung eines Silicium- und Stickstoff-enthaltenden Films nach Anspruch 4, wobei der Stickstoff-enthaltende Reaktant NH₃ ist.

6. Verfahren zur Bildung eines Silicium- und Stickstoff-enthaltenden Films nach Anspruch 5, wobei der monosubstituierte TSA-Vorläufer und der Stickstoff-enthaltende Reaktant gleichzeitig in den Reaktor eingeführt werden.

7. Verfahren zur Bildung eines Silicium- und Stickstoff-enthaltenden Films nach Anspruch 4, wobei der Stickstoff-enthaltende Reaktant Plasma N₂ ist.

8. Verfahren zur Bildung eines Silicium- und Stickstoff-enthaltenden Films nach Anspruch 7, wobei der monosubstituierte TSA-Vorläufer und der Stickstoff-enthaltende Reaktant sequenziell in den Reaktor eingeführt werden.

## Revendications

1. Procédé de formation d'un film contenant du silicium et de l'azote, le procédé comprenant les étapes suivantes :
le dépôt d'un film contenant du silicium et de l'azote sur un substrat par l'introduction d'une vapeur d'un précurseur de TSA monosubstitué et d'un réactif contenant de l'azote dans un réacteur contenant le substrat, le précurseur de TSA monosubstitué présentant une formule (SiH₃)₂N-SiH₂-X, **caractérisé en ce que** X est un groupe amino [-NR₂] et chaque R est sélectionné indépendamment dans le groupe consistant en H ; un groupe hydrocarbyle en C₁ à C₆.

2. Procédé de formation d'un film contenant du silicium et de l'azote selon la revendication 1, dans lequel X est NiPr₂.

3. Procédé de formation d'un film contenant du silicium et de l'azote selon la revendication 1, dans lequel X est NEt₂.

4. Procédé de formation d'un film contenant du silicium et de l'azote selon l'une quelconque des revendications 1 à 3, dans lequel le réactif contenant de l'azote est sélectionné dans le groupe consistant en l'ammoniac, N₂, les atomes N, les radicaux de N, les ions de N, une hydrazine saturée ou insaturée, les amines, les diamines, l'éthanolamine, et les combinaisons de ceux-ci.

5. Procédé de formation d'un film contenant du silicium et de l'azote selon la revendication 4, dans lequel le réactif contenant de l'azote est NH₃.

6. Procédé de formation d'un film contenant du silicium et de l'azote selon la revendication 5, dans lequel le précurseur de TSA monosubstitué et le réactif contenant de l'azote sont introduits dans le réacteur simultanément.

7. Procédé de formation d'un film contenant du silicium et de l'azote selon la revendication 4, dans lequel le réactif contenant de l'azote est un plasma de N₂.

8. Procédé de formation d'un film contenant du silicium et de l'azote selon la revendication 7, dans lequel le précurseur de TSA monosubstitué et le réactif contenant de l'azote sont introduits dans le réacteur de manière séquentielle.
